# EUROPEAN PATENT APPLICATION

(11) **EP 4 814 507 A1**
(43) Date of publication of application: **30.09.2026**
(21) Application number: 25219008.7
(22) Date of filing: 27.11.2025
(51) Int. Cl.: G01R 31/371, G01R 31/392

(54) **APPARATUS FOR DIAGNOSING A BATTERY AND A METHOD THEREOF**

(30) Priority: 24.03.2025 KR 20250037537
(71) Applicant: Hyundai Motor Company, Seoul 06797 (KR); Kia Corporation, Seoul 06797 (KR)
(72) Inventor: LEE, Woo Ju, Hwaseong-si, Gyeonggi-do 18280 (KR); JEONG, Do Hyun, Hwaseong-si, Gyeonggi-do 18280 (KR); KIM, Ju Seok, Hwaseong-si, Gyeonggi-do 18280 (KR); KIM, Min Joo, Hwaseong-si, Gyeonggi-do 18280 (KR)
(74) Representative: Viering, Jentschura & Partner mbB Patent- und Rechtsanwälte

(57) **Abstract**

A battery diagnosing apparatus obtain at least one of first battery data for a battery to which a battery control algorithm associated with battery control is applied, second battery data for a battery to which the battery control algorithm is not applied, or any combination thereof. The battery diagnosing apparatus generates information about a condition of the battery based on at least one of the first battery data, the second battery data, or any combination thereof.

## Description

### CROSS-REFERENCE TO RELATED APPLICATION

This application claims the benefit of and priority to Korean Patent Application No. 10-2025-0037537, filed on March 24, 2025, the entire contents of which are hereby incorporated herein by reference.

### TECHNICAL FIELD

The present disclosure relates to a battery diagnosing apparatus and a method thereof.

### BACKGROUND

The statements in this section merely provide background information related to the present disclosure and may not constitute prior art.

In electric and hybrid vehicles, battery lifespan has a significant impact on vehicle performance and driving efficiency. In particular, in the case of lithium-ion batteries, factors such as the number of charges, the number of discharges, a temperature, and a charging status may affect the battery lifespan.

Conventional battery management systems (BMS) monitor and control various elements associated with batteries, but to extend the long-term life of batteries, a more sophisticated battery control algorithm needs to be applied to the batteries. If the battery control algorithm is applied to a battery, the battery's lifespan and quality may be improved.

However, the battery control algorithm may reduce the marketability of a battery by increasing the charge time of the battery or reducing the mileage of the vehicle, thereby making it difficult to force users to employ the battery control algorithm.

### SUMMARY

The present disclosure was made to solve the above-mentioned problems occurring in the prior art while advantages achieved by the prior art are maintained intact.

Aspects of the present disclosure provide a battery diagnosing apparatus and method that may make a user aware of the status of a battery by providing information about the condition of the battery to the user.

Aspects of the present disclosure provide a battery diagnosing apparatus and method that may provide a user with information effective to cause the user to employ a battery control algorithm, by providing the user with information obtained by comparing the condition of a battery to which a battery control algorithm is applied with the condition of the battery to which the battery control algorithm is not applied.

Aspects of the present disclosure provide a battery diagnosing apparatus and method that may visually deliver information about the status of a battery to a user.

Aspects of the present disclosure provide a battery diagnosing apparatus and method that may improve the durability of a battery by providing a user with information that may cause the user to employ the battery control algorithm.

Aspects of the present disclosure provide a battery diagnosing apparatus and method that may reduce a failure rate of a battery by providing a user with information that may cause the user to employ the battery control algorithm.

The technical problems to be solved by the present disclosure are not limited to the aforementioned problems. Other technical problems not mentioned herein should be more clearly understood from the following description by those having ordinary skill in the art to which the present disclosure pertains.

According to an aspect of the present disclosure, a battery diagnosing apparatus is provided. The battery diagnosing apparatus includes a memory configured to store computer-readable instructions and a processor configured to execute the computer-readable instructions. The processor is configured to obtain at least one of first battery data for a battery to which a battery control algorithm associated with battery control is applied, second battery data for a battery to which the battery control algorithm is not applied, or any combination thereof. The processor is also configured to generate information about a condition of the battery based on at least one of the first battery data, the second battery data, or any combination thereof.

In an embodiment, the processor may be configured to determine at least one of at least one first parameter based on the first battery data, at least one second parameter calculated based on the second battery data, or any combination thereof. The processor may also be configured to determine at least one of first data associated with the condition of the battery based on the at least one first parameter, second data associated with the condition of the battery based on the at least one second parameter, or any combination thereof. The processor may be configured to generate the information about the condition of the battery based on at least one of the first battery data, the second battery data associated with the condition of the battery, the first data associated with the condition of the battery, the second data associated with the condition of the battery, or any combination thereof.

In an embodiment, the processor may be configured to generate the information about the condition of the battery to include information obtained by comparing i) a first state of the battery according to the first data associated with the condition of the battery with ii) a second state of the battery according to the second data associated with the condition of the battery.

In an embodiment, the processor may be configured to obtain data associated with a vehicle that uses the battery. The processor may be configured to generate the information about the condition of the battery based on at least one of the data associated with the vehicle, the at first data associated with the condition of the battery, the second data associated with the condition of the battery, or any combination thereof.

In an embodiment, the processor may be configured to determine the at first data based on at least one of the at least one first parameter, a correction constant corresponding to the at least one first parameter, an adjustment factor corresponding to the at least one first parameter, or any combination thereof. The processor may also be configured to determine the second data based on at least one of the at least one second parameter, a correction constant corresponding to the at least one second parameter, an adjustment factor corresponding to the at least one second parameter, or any combination thereof.

In an embodiment, the processor may be configured to convert the first data associated with the condition of the battery and the second data associated with the condition of the battery to respective predetermined indicators.

In an embodiment, the processor may be configured to display information for recommending application of the battery control algorithm to the battery, on at least one of a display of a vehicle, a terminal of a user, or any combination thereof, based on a result of comparing the first data associated with the condition of the battery converted to a predetermined indicator with the at least one second data converted to the predetermined indicator.

In an embodiment, the processor may be configured to generate the information about the condition of the battery to include at least one of information about a condition of another battery other than a battery of a user, information about a battery used by another user other than the user, or any combination thereof.

In an embodiment, the processor may be configured to determine the information about the condition of the battery based on on a type of the first data associated with the condition of the battery or a type of the second data associated with the condition of the battery.

In an embodiment, the processor may display the information about the condition of the battery on at least one of a display of a vehicle, a terminal of a user, or any combination thereof.

In an embodiment, the processor may display a function associated with the battery control algorithm for the battery being used by a user on at least one of a display of a vehicle, a terminal of a user, or any combination thereof, based on determining that the battery control algorithm is not being applied to the battery being used by the user.

In an embodiment, the processor may display the information about the condition of the battery as visual data including at least one of a graph, a chart, a diagram, or any combination thereof, on at least one of a display of a vehicle, a terminal of a user, or any combination thereof.

In an embodiment, the processor may generate first information obtained by comparing information about a condition of a battery of a user with at least one of information about conditions of batteries of other users who employ the battery control algorithm, information about conditions of batteries of other users who do not employ the battery control algorithm, or any combination thereof.

In an embodiment, the processor may generate second information obtained by comparing, corresponding to one or more types of reference data, information about a condition of a battery of a user with at least one of information about conditions of batteries of other users who employ the battery control algorithm, information about conditions of batteries of other users who do not employ the battery control algorithm, or any combination thereof. The one or more types of reference data may include at least one of state of charge (SOC) of the battery, state of health (SOH) of the battery, a degradation rate of the battery, a cooling load of the battery, a charging load of the battery, data associated with thermal control of the battery, power consumption efficiency of the battery, or any combination thereof.

In an embodiment, the processor may generate third information about the condition of the battery of the user corresponding to one among the one or more types reference data. The third information may include at least one of information about the condition of the battery of a user, information about conditions of batteries of multiple users including the user, information about conditions of batteries of other users other than the user, or any combination thereof.

In an embodiment, the processor may generate fourth information about the condition of the battery of the user corresponding to one among the one or more types of reference data. The fourth information may include at least one of information about the condition of the battery of the user, the information about the conditions of the batteries of the other users who employ the battery control algorithm, the information about the conditions of the batteries of the other users who do not employ the battery control algorithm, or any combination thereof.

In an embodiment, the processor may generate fifth information obtained by comparing the first data converted into a predetermined indicator with the second data converted into the predetermined indicator, corresponding to one or more types of reference data. The fifth information may include information about a difference between the first data and the second data. The one or more types of reference data may include at least one of SOC of the battery, SOH of the battery, a degradation rate of the battery, a cooling load of the battery, a charging load of the battery, data associated with thermal control of the battery, power consumption efficiency of the battery, or any combination thereof.

According to another aspect of the present disclosure, a battery diagnosing method is provided. The battery diagnosing method includes obtaining, by a processor, at least one of first battery data for a battery to which a battery control algorithm associated with battery control is applied, second battery data for a battery to which the battery control algorithm is not applied, or any combination thereof. The battery diagnosing method also includes generating, by the processor, information about a condition of the battery based on at least one of the first battery data, the second battery data, or any combination thereof.

According to an embodiment of the present disclosure, the battery diagnosing method may further include determining, by the processor, at least one of at least one first parameter based on the first battery data, at least one second parameter based on the second battery data, or any combination thereof. The battery diagnosing method may also include determining, by the processor, at least one of first data associated with the condition of the battery based on the at least one first parameter, second data associated with the condition of the battery based on the at least one second parameter, or any combination thereof. Generating the information about the condition of the battery may include generating the information about the condition of the battery based on at least one of the first data associated with the condition of the battery, the second data associated with the condition of the battery, or any combination thereof.

According to an embodiment, generating the information about the condition of the battery may include generating the information about the condition of the battery to include information obtained by comparing a first state of the battery according to the first data associated with the condition of the battery with a second state of the battery according to the second data.

### BRIEF DESCRIPTION OF THE DRAWINGS

The above and other objects, features, and advantages of the present disclosure should be more apparent from the following detailed description taken in conjunction with the accompanying drawings, in which:
FIG. 1 is a block diagram showing a battery diagnosing apparatus, according to an embodiment of the present disclosure;
FIG. 2 is a drawing showing an example of a process in which a battery control algorithm is applied to a vehicle battery by a battery diagnosing apparatus, according to an embodiment of the present disclosure;
FIG. 3 is a diagram showing a process in which a battery diagnosing apparatus identifies a parameter from battery data to diagnose a battery, according to an embodiment of the present disclosure;
FIG. 4 is a diagram showing a process in which a battery diagnosing apparatus analyzes data associated with a condition of a battery based on a parameter, according to an embodiment of the present disclosure;
FIG. 5 is a distribution diagram of batteries to which a battery control algorithm is applied and batteries to which the battery control algorithm is not applied, according to a driving period of a vehicle and a mileage of the vehicle, where the distribution diagram is generated by a battery diagnosing apparatus, according to an embodiment;
FIG. 6A is a diagram showing an example of a comprehensive score of a battery condition displayed on a display by a battery diagnosing apparatus, according to an embodiment of the present disclosure;
FIG. 6B is a drawing showing an example of an indicator-specific score of a battery condition displayed on a display by a battery diagnosing apparatus, according to an embodiment of the present disclosure;
FIG. 7A is a drawing showing an example of a result of comparing the SOH of a battery used by a user and batteries used by multiple users, which is displayed on a display by a battery diagnosing apparatus, according to an embodiment of the present disclosure;
FIG. 7B is a drawing showing an example of the results of analyzing the SOH of a battery according to whether LCM is used, which is displayed on a display by a battery diagnosing apparatus, according to an embodiment of the present disclosure;
FIG. 8 is a drawing showing an example of an indicator-specific score of a battery condition expected if LCM is used, which is displayed on a display by a battery diagnosing apparatus, according to an embodiment of the present disclosure;
FIG. 9 is a flowchart showing an example of a data preprocessing process performed by a battery diagnosing apparatus, according to an embodiment of the present disclosure;
FIG. 10 is a flowchart showing an example of generating first pattern information during a data preprocessing process performed by a battery diagnosing apparatus, according to an embodiment of the present disclosure;
FIG. 11A is a flowchart showing an example of obtaining second pattern information during a data preprocessing process performed by a battery diagnosing apparatus, according to an embodiment of the present disclosure;
FIG. 11B is a flowchart showing a detailed example of obtaining second pattern information during a data preprocessing process performed by a battery diagnosing apparatus, according to an embodiment of the present disclosure;
FIG. 12 is a flowchart for describing a battery diagnosing apparatus or a battery diagnosing method, according to an embodiment of the present disclosure; and
FIG. 13 is a diagram showing a computing system associated with a battery diagnosing apparatus or a battery diagnosing method, according to an embodiment of the present disclosure.

### DETAILED DESCRIPTION

Hereinafter, embodiments of the present disclosure are described in detail with reference to the accompanying drawings. In adding reference numerals to components of each drawing, it should be noted that the same components are designated by the same reference numerals even when the components are illustrated in different drawings. Furthermore, in describing the embodiments of the present disclosure, where it was determined that a detailed description of a well-known function or configuration would obscure the gist of the present disclosure, the detailed description thereof has been omitted.

In describing elements of an embodiment of the present disclosure, the terms first, second, A, B, (a), (b), and the like may be used herein. These terms are only used to distinguish one element from another element, but do not limit the corresponding elements irrespective of the nature, order, or priority of the corresponding elements. Moreover, expressions such as "at least one of A, B, C, or any combination thereof" may include "A, B, or C, or any combination thereof such as AB, BC, AC, or ABC".

Furthermore, unless otherwise defined, all terms used herein, including technical or scientific terms, have the same meaning as commonly understood by one of ordinary skill in the technical art to which the present disclosure belongs. It should be understood that terms used herein should be interpreted as having a meaning that is consistent with their meaning in the context of the present disclosure and the relevant art and should not be interpreted in an idealized or overly formal sense unless expressly so defined herein.

When a component, controller, device, element, apparatus, unit or the like of the present disclosure is described as having a purpose or performing an operation, function, or the like, the component, controller, device, element, apparatus, unit or the like should be considered herein as being "configured to" meet that purpose or to perform that operation or function. Each component, controller, device, element, apparatus, unit, or the like may separately embody or be included with one or more processors and a memory, such as a non-transitory computer-readable media, as part of the apparatus. The one or more processors may be configured to implement computer-readable instructions stored in the memory to perform the described operations.

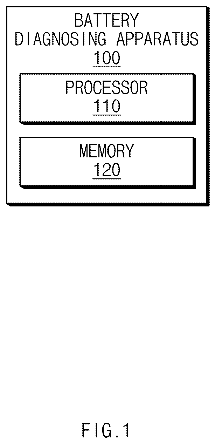

Hereinafter, embodiments of the present disclosure are described in detail with reference to FIGS. 1 - 13.

FIG. 1 is a block diagram showing a battery diagnosing apparatus, according to an embodiment of the present disclosure.

A battery diagnosing apparatus 100 may be implemented in a vehicle, according to an embodiment. For example, the battery diagnosing apparatus 100 may be integrated with internal control units of a vehicle, or may be implemented with a separate device so as to be coupled with control units of the vehicle via a separate connection device.

The battery diagnosing apparatus 100 may be implemented as a server located outside a vehicle, according to another embodiment. For example, the battery diagnosing apparatus 100 may be implemented as a cloud server. In this case, the battery diagnosing apparatus 100 may exchange data with the vehicle via a communication network.

According to an embodiment, the battery diagnosing apparatus 100 may include a processor 110 and a memory 120. The configuration of the battery diagnosing apparatus 100 shown in FIG. 1 is an example, and the present disclosure is not limited thereto. For example, the battery diagnosing apparatus 100 may further include components not illustrated in FIG. 1.

According to an embodiment, the memory 120 may store computer-readable instructions and/or data. For example, the memory 120 may store one instruction or two or more instructions that, when executed by the processor 110, cause the battery diagnosing apparatus 100 to perform various operations.

According to an embodiment, the memory 120 may be implemented as a single chipset with the processor 110 and may store various pieces of information associated with the battery diagnosing apparatus 100. For example, the memory 120 may store information about the operating history of the processor 110.

According to an embodiment, the memory 120 may include a non-volatile memory (a read only memory (ROM)) and/or a volatile memory (a random access memory (RAM)).

According to an embodiment, the memory 120 may store a battery control algorithm associated with control of a battery. For example, the battery control algorithm may include a strategy for controlling the battery.

According to an embodiment, the battery control algorithm may include Life Cycle Management (LCM). The LCM may include an algorithm that manages the life cycle of the battery. In an example, the LCM may extend the lifespan of the battery by controlling the initially designed charge current or limiting the range of SOC where the battery is used.

According to an embodiment, the battery control algorithm may include an algorithm for optimizing the performance and/or lifespan of the battery. For example, the battery control algorithm may include an algorithm that improves the performance and/or lifespan of the battery by controlling at least one of a battery charge pattern, a battery discharge pattern, a battery temperature, a battery voltage, a battery current, or any combination thereof.

According to an embodiment, the processor 110 may identify at least one of first battery data for a battery to which a battery control algorithm associated with battery control is applied, second battery data for a battery to which the battery control algorithm is not applied, or any combination thereof.

According to an embodiment, the processor 110 may generate information about the condition of the battery based on at least one of the first battery data, the second battery data, or any combination thereof.

According to an embodiment, the processor 110 may identify at least one of at least one first parameter calculated based on the first battery data, at least one second parameter calculated based on the second battery data, or any combination thereof.

According to an embodiment, the battery data may include at least one of a battery voltage, a battery current, a battery temperature, or any combination thereof. As used herein, the battery may be understood to include a battery cell, a battery module, a battery pack, or a BMS.

According to an embodiment, the processor 110 may identify the first battery data associated with a battery to which the battery control algorithm is applied. For example, the battery to which the battery control algorithm is applied may include a battery being controlled by the battery control algorithm. In an embodiment, the battery controlled by the battery control algorithm may include a battery in which at least one of a battery charge pattern, a battery discharge pattern, a battery temperature, a battery voltage, a battery current, or any combination thereof, is controlled according to the battery control algorithm.

According to an embodiment, the processor 110 may identify the second battery data for a battery to which the battery control algorithm is not applied. For example, the battery to which the battery control algorithm is not applied may include a battery that is not controlled by the battery control algorithm.

According to an embodiment, the battery that is not controlled by the battery control algorithm may have a shorter lifespan and/or lower efficiency than the battery that is controlled by the battery control algorithm.

According to an embodiment, the processor 110 may calculate a parameter based on battery data. For example, the parameter may include a parameter associated with a battery. As a specific example, the parameter may include at least one of the state of charge (SOC) of a battery, the state of health (SOH) of the battery, a variable associated with loss of active material of the battery, Li-plating, a temperature, charge capacity, discharge capacity, theoretical capacity, internal resistance of the battery, a diffusion coefficient, porosity, or any combination thereof. In an embodiment, the SOH of the battery may indicate the remaining capacity of the battery.

According to an embodiment, the processor 110 may identify at least one first parameter calculated based on the first battery data. For example, the first parameter may include a parameter calculated from a battery to which the battery control algorithm is applied.

According to an embodiment, the processor 110 may identify at least one second parameter calculated based on the second battery data. For example, the second parameter may include a parameter calculated from a battery to which the battery control algorithm is not applied.

According to an embodiment, the first parameter or the second parameter may include a parameter associated with the battery. As a specific example, the first parameter or the second parameter may include at least one of the SOC of a battery, the SOH of the battery, a variable associated with loss of active material of the battery, Li-plating, a temperature, charge capacity, discharge capacity, theoretical capacity, internal resistance of the battery, a diffusion coefficient, porosity, or any combination thereof.

According to an embodiment, the processor 110 may calculate at least one of first data associated with a condition of a battery based on the at least one first parameter, second data associated with a condition of the battery based on the at least one second parameter, or any combination thereof.

According to an embodiment, the data associated with the condition of the battery may include data based on which the condition of the battery can be determined.

According to an embodiment, data associated with the condition of the battery may include data associated with a diagnostic indicator.

According to an embodiment, the diagnostic indicator may include an indicator associated with the condition of a battery. Specific details associated with the diagnostic indicator, according to embodiments, are described in more detail.

In an example, the condition of a battery may include the SOH of the battery.

According to an embodiment, the condition of the battery may include factors that determine the performance, safety, lifespan, and/or operability of the battery, by comprehensively evaluating the electrical, thermal, physical, and chemical characteristics of the battery.

According to an embodiment, the condition of the battery may include the electrical state of the battery, the thermal state of the battery, the physical and structural state of the battery, the chemical state of the battery, a state associated with the usage history and charge and discharge patterns of the battery, and the state associated with the safety and abnormality of the battery.

For example, the electrical state of a battery may include the SOC, SOH, and State of Power (SOP) of the battery. The processor 110 may evaluate the performance, charge characteristics, and discharge characteristics of a battery via indicators such as voltage, current, and internal resistance of the battery.

The thermal state of the battery may include a state for detecting temperature changes and overheating of the battery. The processor 110 may evaluate whether the battery is operating within a safe operating range, by analyzing the temperature gradient and thermal runaway onset temperature of the battery.

The physical and structural state of a battery may include whether there is balancing between battery cells, whether there is cell swelling, and internal resistance.

The chemical state occurring inside the battery may include a state associated with the stability of a Solid Electrolyte Interphase (SEI) layer, an electrolyte condition, whether dendrite is formed, and whether gas is generated.

The state associated with the usage history and charge and discharge patterns of the battery may include states associated with charge and discharge cycle counts, charging/discharging efficiency, and depth of discharge (DOD).

The state associated with the safety and abnormality of the battery may include whether a battery reaches an overcharge or over-discharge state, whether abnormal heating is detected in a specific cell, and/or whether there is a risk of an internal short circuit.

According to an embodiment, the data associated with a battery condition may include an indicator based on which the condition of the battery can be determined. For example, the data associated with the battery condition may include at least one of the SOC of the battery, the SOH of the battery, the degradation rate of the battery, the cooling load of the battery, the charging load of the battery, data associated with thermal control of the battery, the power consumption efficiency of the battery, or any combination thereof.

According to an embodiment, the processor 110 may calculate first data associated with the condition of a battery based on the at least one first parameter. For example, the first data may include data associated with a battery to which the battery control algorithm is applied.

According to an embodiment, the processor 110 may calculate second data associated with the condition of a battery based on the at least one second parameter. For example, the second data may include data associated with a battery to which the battery control algorithm is not applied.

According to an embodiment, the first data and/or the second data may include an indicator based on which the condition of a battery can be determined. For example, the first data and/or the second data may include at least one of the SOC of the battery, the SOH of the battery, the degradation rate of the battery, the cooling load of the battery, the charging load of the battery, data associated with thermal control of the battery, the power consumption efficiency of the battery, or any combination thereof.

According to an embodiment, the processor 110 may generate information about the condition of a battery based on at least one of the first data, the second data, or any combination thereof.

According to an embodiment, information about the condition of a battery may include various pieces of information for checking the SOH of the battery.

For example, the information about the condition of a battery may include at least one of information about values determined comprehensively by indicators for the condition of the battery, information about a value obtained by determining the condition of the battery for each indicator, information analyzed in detail for each indicator associated with the condition of the battery, information obtained by comparing the condition of the battery employed by a user with conditions of batteries employed by other users, information about the condition of the battery to which the battery control algorithm is applied, information about the condition of the battery to which the battery control algorithm is not applied, information about the condition of the battery expected if the battery control algorithm is applied, or any combination thereof. However, this is only an example, and the present disclosure is not limited thereto. The information about the battery condition may generally include various pieces of information about the battery condition.

According to an embodiment, the processor 110 may display the information about the condition of the battery on at least one of a display of a vehicle, a terminal of a user, or any combination thereof.

For example, the display of the vehicle may include at least one of a cluster, a head-up display (HUD), a center information display (CID), a co-driver display (CDD), a side mirror display, a rear seat entertainment display, or any combination thereof.

In an embodiment, if a touch sensor such as a touch film, a touch sheet, or a touch pad is included in the display, the display may operate as a touch screen and may be implemented in the form in which the input device and the output device are integrated with each other.

According to an embodiment, the processor 110 may display the information about the condition of the battery on the display of the terminal of the user. For example, the terminal of the user may include a mobile phone, a tablet PC, a laptop PC, a wearable device, a game console, a speaker, and/or the like.

According to an embodiment, the processor 110 may transmit the information about the condition of the battery to at least one of a display of a vehicle, a terminal of a user, or any combination thereof. For example, the processor 110 may transmit data including the information about the condition of the battery to at least one of the display of the vehicle, the terminal of the user, or any combination thereof, by using wired or wireless communication. For example, the processor 110 may be communicatively coupled to a communication circuit via which the processor 110 may transmit data including the information about the condition of the battery to at least one of the display of the vehicle, the terminal of the user, or any combination thereof, by using wired or wireless communication.

According to an embodiment, the communication circuit may include a circuit for wireless Internet access. For example, the communication circuit may access a wireless communication network of a wireless communication provider and thus wireless communication such as 3G, Long Term Evolution (LTE), Long Term Evolution-Advanced (LTE-A), or fifth generation mobile communications (5G) may be utilized. Moreover, the communication circuit may be mounted on a telematics unit and may include a Radio Frequency (RF) antenna and a communication control module. The communication circuit may be provided in at least one of the battery diagnosing apparatus 100, the vehicle, the terminal of the user, or any combination thereof.

According to an embodiment, the processor 110 may generate information about the condition of a battery including information obtained by comparing a first state of the battery according to first data with a second state of the battery according to second data.

In an example, the first state may include the condition of the battery to which the battery control algorithm is applied. In an example, the second state may include the condition of the battery to which the battery control algorithm is not applied.

According to an embodiment, the first state of the battery and the second state of the battery may be converted into scores, respectively. In this case, the score for the first state may be higher than the score for the second state.

For example, the performance of a battery according to the first state may be better than the performance of a battery according to the second state. As another example, the lifespan of a battery in the first state may be longer than the lifespan of a battery in the second state. As another example, the SOH of a battery according to the first state may be higher than the SOH of a battery according to the second state. As another example, the degradation rate of the battery according to the first state may be slower than the degradation rate of the battery according to the second state. As another example, the power consumption efficiency of the battery according to the first state may be higher than the power consumption efficiency of the battery according to the second state.

According to an embodiment, the processor 110 may identify data associated with the condition of a battery from a plurality of users who employ a specific type of battery. In an embodiment, the particular type of battery may include batteries whose conditions can be compared with each other.

For example, the processor 110 may identify at least one of data associated with battery conditions of users employing the battery control algorithm, data associated with battery conditions of users not employing the battery control algorithm, or any combination thereof.

For example, the processor 110 may calculate an average value by using data associated with battery conditions of other users. For example, the processor 110 may calculate or otherwise determine an average value for each indicator of data associated with the battery conditions of other users.

It is noted that although terms "calculate," "calculating," "calculated," and variations thereof, in connection with a value, an amount, an average, data, etc., and variations thereof, may be used in the present disclosure, this is merely for convenience of explanation and the present disclosure is not limited thereto. In some embodiments, the value, the amount, the average, the data, etc. may be determined in other suitable manners.

As another example, the processor 110 may identify an average value calculated by using data associated with the battery conditions of other users. For example, the processor 110 may obtain data associated with the average value from an external server without directly calculating the average value.

As a concrete example, the processor 110 may calculate the average value of SOH of batteries used by multiple users. The processor 110 may calculate the average value of the SOH of batteries to which the battery control algorithm is applied. The processor 110 may calculate the average value of SOH of batteries to which the battery control algorithm is not applied.

According to an embodiment, the processor 110 may identify data associated with a vehicle that is equipped with a battery.

According to an embodiment, the data associated with the vehicle may include at least one of a type of the vehicle, a model year of the vehicle, the mileage of the vehicle, a driving period of the vehicle, an average speed of the vehicle, a driving style of the vehicle, information about the battery included in the vehicle, whether a battery control algorithm is used, or any combination thereof.

According to an embodiment, the processor 110 may generate information about the condition of a battery based on at least one of data associated with a vehicle equipped with the battery, the first data associated with the condition of the battery, the second data associated with the condition of the battery, or any combination thereof.

In an example, the processor 110 may generate information about the condition of a battery based on first data for the same vehicle type. For example, the processor 110 may identify the first data obtained for a battery included in the same vehicle type and may generate information about the condition of the battery based on the identified first data. Accordingly, in generating information about the condition of the battery, the processor 110 may consider information about the vehicle.

In an example, the processor 110 may specify a range of mileage of the vehicle, and may generate information about the battery condition by using at least one of the first data, the second data, or any combination thereof, within the specified mileage range.

As a specific example, the processor 110 may identify batteries included in vehicles having a mileage of 10,000 kilometers (km) or more and 20,000 km or less (i.e., mileage in the range between 10,000 km and 20,000 km). Moreover, the processor 110 may distinguish between batteries that use a battery control algorithm and batteries that do not use the battery control algorithm, among the identified batteries, and may identify the distinguished batteries.

According to an embodiment, the processor 110 may generate an analysis group based on at least one of data associated with a vehicle equipped with a battery, the first data associated with the condition of the battery, the second data associated with the condition of the battery, or any combination thereof.

According to an embodiment, the processor 110 may generate the analysis group by combining various pieces of information included in the data associated with the vehicle, the first data, and/or the second data.

For example, the analysis groups may include groups classified based on whether the battery control algorithm is used.

As another example, the analysis groups may include groups categorized by the mileage of a vehicle and the driving period of the vehicle.

According to an embodiment, the processor 110 may generate information about the battery condition based on the analysis group. For example, the processor 110 may select the analysis group required to analyze the condition of the battery and may generate information about the battery condition by using data included in the selected analysis group. As another example, the processor 110 may generate information about the battery condition by using data included in a plurality of analysis groups.

According to an embodiment, in generating data associated with the condition of a battery, the processor 110 may use at least one of a correction constant corresponding to a parameter, an adjustment factor corresponding to the parameter, or any combination thereof.

According to an embodiment, the correction constant may include a fixed value for modifying a specific value to reduce errors or incompleteness. In an embodiment, the correction constant may include a constant determined for each particular vehicle.

According to an embodiment, the adjustment factor may include a variable value for reflecting a value that may change depending on external factors.

According to an embodiment, the processor 110 may calculate first data based on at least one of at least one first parameter, a correction constant corresponding to the at least one first parameter, an adjustment factor corresponding to the at least one first parameter, or any combination thereof.

According to an embodiment, the processor 110 may calculate second data based on at least one of at least one second parameter, a correction constant corresponding to the at least one second parameter, an adjustment factor corresponding to the at least one second parameter, or any combination thereof.

According to an embodiment, the processor 110 may convert the first data and the second data into predetermined indicators, respectively.

For example, the predetermined indicator may include at least one of the SOC of the battery, the SOH of the battery, the degradation rate of the battery, the cooling load of the battery, the charging load of the battery, data associated with thermal control of the battery, or any combination thereof.

According to an embodiment, the predetermined indicator may include a diagnostic indicator. According to an embodiment, the diagnostic indicator may include an indicator associated with the condition of a battery.

The diagnostic indicator may indicate the power performance that the battery may produce instantaneously under specific conditions. For example, the diagnostic indicator may include State of Power (SOP), which is an indicator that evaluates the output characteristics of a battery and indicates the speed at which the battery may be charged and discharged. As another example, the diagnostic indicator may include a charge and discharge speed (C-Rate), such as 1C, that indicates the speed at which a battery is fully charged and discharged within one hour. As another example, the diagnostic indicator may include a resistance value (e.g., the internal resistance) that impedes the current flow inside the battery, which may cause increased heat generation and performance degradation as the internal resistance increases. As another example, the diagnostic indicator may include a voltage difference between battery cells, that may indicate the voltage deviation that may cause performance degradation and shortened lifespan due to the severe imbalance between cells as the voltage deviation increases or the number of charge and discharge cycles that the battery may be used normally.

As another example, the diagnostic indicator may include the charge and discharge life (cycle life), which may be evaluated as the number of cycles that the performance is maintained up to specific capacity (e.g., 80% of the initial capacity) of the battery. As another example, the diagnostic indicator include a ratio of capacity maintained over time to the initial capacity of the battery. High capacity retention refers to the capacity retention, which indicates the long-term performance stability of the battery. As another example, the diagnostic indicator may include the ratio of the actual usable charge, or Coulombic Efficiency, in the battery charging and discharging process, which means that the closer it is to 100%, the less energy is lost.

As another example, the diagnostic indicator may include the rate at which a battery is naturally discharged in an unused state, which may be referred to as the self-discharge rate, that may indicate that the battery performance may be maintained even if energy is stored for a long time as the self-discharge rate is low. As another example, the diagnostic indicator may include the temperature at which spontaneous thermal runaway begins if the battery is heated above a specific temperature, which may be referred to as the thermal runaway onset temperature, that is an important criterion for battery safety evaluation, or a temperature difference inside the battery or between cells. A high temperature gradient may be a temperature gradient that may cause an imbalance between cells, thereby shortening the lifespan and reducing performance. As another example, the diagnostic indicator may include the speed at which heat spreads inside the battery, or thermal conductivity, where the higher the thermal conductivity, the more evenly the heat is distributed, thereby reducing the risk of overheating. As another example, the diagnostic indicator may include the amount of energy that may be stored per unit volume (Wh/L) or unit weight (Wh/kg) of a battery, or energy density, which is an important indicator for miniaturization and weight reduction of the battery, and may indicate the amount of power that may be instantaneously generated per unit volume (W/L) or unit weight (W/kg) of the battery.

As another example, the diagnostic indicator may include power density, which is suitable for high-power applications (e.g., electric vehicles, drones, etc.) as the power density is high, and may indicate a ratio at which the energy supplied to the battery during charging is actually stored. As another example, the diagnostic indicator may include charging efficiency, which may indicate less energy loss and economical battery operation as the charging efficiency increases. As another example, the diagnostic indicator may include a discharge ratio compared to the total capacity of the battery, and indicate depth of discharge (DOD), where the battery is discharged more deeply as the DOD increases.

As another example, the diagnostic indicator includes the degree to which voltage balance is maintained between individual cells in the battery composed of a plurality of cells, and may indicate cell balancing efficiency, which may deteriorate battery performance due to overcharge/overdischarge of some cells if balancing efficiency is low. As another example, the diagnostic indicator includes include the time required to charge the battery to a specific SOC, and may indicate a charge time, which is advantageous for fast charging as the charge time is shorter. As another example, the diagnostic indicator may include the time required for the battery to be completely discharged at a constant power output, and may include discharge time, which may improve battery usability as the discharge time is longer.

According to an embodiment, in converting the data associated with the condition of a battery into a predetermined indicator, the processor 110 may use at least one of a parameter, a correction constant, an adjustment factor, or any combination thereof.

For example, the processor 110 may convert the first data into a predetermined indicator based on at least one of a first parameter, a correction constant corresponding to the first parameter, an adjustment factor corresponding to the first parameter, or any combination thereof.

As another example, the processor 110 may convert the second data into a predetermined indicator based on at least one of a second parameter, a correction constant corresponding to the second parameter, an adjustment factor corresponding to the second parameter, or any combination thereof.

In an example, the processor 110 may convert both the first data and the second data into the same unit so as to compare the first data with the second data.

For example, the processor 110 may convert data associated with the SOH of the battery into a unit of percentage (%) based on at least one of the SOH of the battery, an adjustment factor associated with the SOH, or any combination thereof.

As another example, the processor 110 may adjust data associated with the SOH of the battery based on at least one of SOH in unit of percentage, an adjustment factor associated with the SOH, or any combination thereof. For example, the processor 110 may adjust the SOH of the battery by adding the adjustment factor associated with the SOH to the SOH of the battery.

According to an embodiment, the processor 110 may convert data associated with the degradation rate of a battery into a score based on at least one of past SOH, current SOH, an adjustment factor associated with the degradation rate of the battery, a correction constant associated with the degradation rate of the battery, or any combination thereof. For example, the processor 110 may convert data associated with the degradation rate of the battery into a score by using an equation of {100 - correction constant associated with degradation rate of battery * (past SOH - current SOH) + adjustment factor associated with degradation rate of battery}.

According to an embodiment, the processor 110 may convert data associated with the cooling load of the battery into a score based on at least one of initial resistance, current resistance, a correction constant associated with the cooling load of the battery, an adjustment factor associated with the cooling load of the battery, or any combination thereof. For example, the processor 110 may convert data associated with the cooling load of the battery into a score by using an equation of {100 - correction constant associated with cooling load of battery * (current resistance/initial resistance) + adjustment factor associated with cooling load of battery}.

According to an embodiment, the processor 110 may convert data associated with the charging load of the battery into a score based on at least one of the loss amount of an active material, a correction constant associated with the charging load of the battery, an adjustment factor associated with the charging load of the battery, or any combination thereof. For example, the processor 110 may convert data associated with the charging load of the battery into a score by using an equation {100 - (correction constant associated with charging load of battery * loss amount of active material) + adjustment factor associated with charging load of battery}.

According to an embodiment, the processor 110 may convert data associated with thermal control of the battery into a score based on at least one of a time during which the temperature of the battery exceeds a threshold temperature, a difference value between the temperature of the battery and a threshold temperature, a correction constant associated with thermal control of the battery, an adjustment factor associated with thermal control of the battery, or any combination thereof. For example, the processor 110 may convert data associated with the thermal control of a battery into a score by using an equation of {100 - (correction constant associated with thermal control of battery * time during which battery temperature exceeds threshold temperature) + (correction constant associated with thermal control of battery * difference value between battery temperature and threshold temperature) + adjustment factor associated with thermal control of battery}.

According to an embodiment, the processor 110 may convert data associated with the power consumption efficiency of a battery into a score based on at least one of the initial power consumption efficiency of the battery, the current power consumption efficiency of the battery, an adjustment factor associated with the power consumption efficiency of the battery, or any combination thereof. For example, the processor 110 may convert data associated with the power consumption efficiency of a battery into a score by using an equation of {100 - (current power consumption efficiency/initial power consumption efficiency) + adjustment factor associated with power consumption efficiency of battery}.

According to an embodiment, the processor 110 may synthesize data associated with the condition of the battery and may convert the synthesized result into a score. For example, the processor 110 may calculate a comprehensive score for the condition of the battery by using an equation of {(w₁ * score of data associated with SOH) + (w₂ * score of data associated with degradation rate) + (w₃ * score of data associated with cooling load) + (w₄ * score of data associated with charging load) + (w₅ * score of data associated with thermal control) + (w₆ * score of data associated with power consumption efficiency)}. In an embodiment, {w₁ + w₂ + w₃ + w₄ + w₅ + w₆ = 1} may be satisfied. In an embodiment, w₁, w₂, w₃, w₄, w₅, and w₆ may include constants set per vehicle.

According to an embodiment, the processor 110 may display information for recommending application of a battery control algorithm to a battery employed by a vehicle on at least one of a display of the vehicle, a terminal of a user, or any combination thereof, based on the result of comparing the first data converted into a predetermined indicator with the second data converted into a predetermined indicator.

For example, the processor 110 may convert the first data and the second data into scores, respectively. The processor 110 may generate information obtained by comparing the score of the first data with the score of the second data. In an embodiment, the processor 110 may generate information that may display scores of the first data and the score of the second data on a display by using a chart, a graph, or a Venn diagram.

According to an embodiment, because the first data is data for a battery to which a battery control algorithm is applied, and the second data is data for a battery to which the battery control algorithm is not applied, the score of the first data may be higher than the score of the second data.

According to an embodiment, if the user is not employing the battery control algorithm, the processor 110 may display information indicating that the score of the first data is higher than the score of the second data on at least one of the display of a vehicle, the terminal of a user, or any combination thereof.

According to an embodiment, if the user is not employing the battery control algorithm, the processor 110 may display information for recommending use of the battery control algorithm on at least one of the display of a vehicle, the terminal of a user, or any combination thereof.

According to an embodiment, the processor 110 may generate information about a battery condition including at least one of information about a condition of a battery other than the user's battery, information about a battery used by another user other than the user, or any combination thereof.

According to an embodiment, the battery other than the user's battery may include another battery for comparing the condition of the user's battery. For example, the battery other than the user's battery may include the same type of battery as the user's battery type. For example, the battery other than the user's battery may include a battery installed in a vehicle of the same type as the user's vehicle. As another example, the battery other than the user's battery may include a battery of a different type from the user's battery type.

According to an embodiment, the information about a battery used by another user other than the user may include information associated with multiple (e.g., all) users who employ the same type of battery as the user's battery type.

According to an embodiment, the processor 110 may identify information about the battery condition based on the type of data associated with the battery condition.

For example, the type of data associated with the battery condition may include at least one of the SOC of the battery, the SOH of the battery, the degradation rate of the battery, the cooling load of the battery, the charging load of the battery, data associated with thermal control of the battery, the power consumption efficiency of the battery, or any combination thereof.

According to an embodiment, information about the battery condition may include information about the SOC of the battery. For example, information about the SOC of a battery may include the SOC of the user's battery, the average SOC of batteries of multiple (e.g., all) users, information for comparing the SOC of the user's battery with the average SOC of batteries of multiple (e.g., all) users, the SOC of a battery to which a battery control algorithm is applied, the SOC of a battery to which the battery control algorithm is not applied, or the like.

This is just one example. Similar to information about the SOC of the battery described above, information about the battery condition may include specific information about the SOH of a battery, the degradation rate of the battery, the cooling load of the battery, the charging load of the battery, data associated with thermal control of the battery, and the power consumption efficiency of the battery.

According to an embodiment, the processor 110 may identify information about the condition of a battery based on the type of the first data or the type of the second data.

According to an embodiment, the first data may include data to which the battery control algorithm is applied, and the second data may include data to which the battery control algorithm is not applied. In an example, the type of the first data and the type of the second data may include the same type as each other.

According to an embodiment, the processor 110 may display a function associated with the battery control algorithm for a battery being used by a user on at least one of the display of the vehicle, the terminal of the user, or any combination thereof, based on the battery control algorithm not being applied to the battery being used by the user.

According to an embodiment, the function associated with the battery control algorithm may include various functions such as charge and discharge management, temperature and thermal management, battery protection, energy regeneration and efficiency optimization, monitoring and safety management, and/or smart control functions.

With the function of the charge and discharge management, the battery may optimize charging power to efficiently store energy and may switch between fast and slow charging modes as needed. Furthermore, to protect the life of the battery, an optimal charging end point may be set and the discharge rate may be adjusted to maximize energy efficiency.

The function of the battery temperature and thermal management may include a function of preventing overheating via a thermal management system that regulates the temperature of the battery to an optimal range and operating a cooling system as necessary. Additionally, or alternatively, the function of the battery temperature and thermal management may include a preconditioning function of preventing battery performance degradation even in extreme temperature environments, and a function of limiting output if the battery overheats.

The function of battery protection may be included via a cell balancing function of adjusting the voltage balance between battery cells.

The function of energy regeneration and efficiency optimization may include an energy optimization function of automatically adjusting regenerative braking (Regen Braking) intensity if a vehicle decelerates to maximize battery charging efficiency, and analyzing driving conditions to set an optimal energy usage pattern. Additionally, or alternatively, the function of energy regeneration and efficiency optimization may include an eco-mode function to minimize battery energy consumption and to increase mileage.

The function of monitoring and safety may include a function of monitoring in real time data such as the SOC, SOH, voltage, current, and temperature of a battery, a function of activating a warning system in the event of risks such as overcharge, overdischarge, and thermal runaway, and a function of immediately cutting off the battery's power supply in the event of an internal short circuit or other hazard.

The function of smart control may include a function of Vehicle-to-Grid (V2G) or Vehicle-to-Home (V2H) that allows the vehicle's battery to be used as a power grid or household power source, a smart charging scheduling function of setting the optimal charge time in consideration of electricity rates and charging station availability, and a function of maintaining battery performance by adjusting the charging strategy based on external weather information. According to an embodiment, the function associated with a battery control algorithm may include a function associated with whether the battery control algorithm is applied.

The function associated with whether to apply the battery control algorithm may include a function of applying the battery control algorithm in a state where the battery control algorithm is not applied, or a function of not applying the battery control algorithm in a state where the battery control algorithm is applied. Accordingly, a user may efficiently control a battery via the functions associated with whether to apply the battery control algorithm.

According to an embodiment, the processor 110 may provide the user with a function that allows the user to use the battery control algorithm if the user is currently not employing the battery control algorithm.

For example, the processor 110 may display a button for starting using the battery control algorithm on at least one of a vehicle's display, the user's terminal, or any combination thereof. In an embodiment, the button for starting using the battery control algorithm may include a button capable of being selected by a touch on the display.

According to an embodiment, the user may apply a battery control algorithm to a battery by selecting a button for starting using the battery control algorithm displayed on the vehicle's display or the user's terminal.

According to an embodiment, the processor 110 may display information about the condition of the battery as visual data including at least one of a graph, a chart, a diagram, or any combination thereof, on at least one of the vehicle's display, the user's terminal, or any combination thereof.

According to an embodiment, the processor 110 may display visual data obtained by comparing information about the condition of a battery to which a battery control algorithm is applied with information about the condition of a battery to which the battery control algorithm is not applied, on at least one of the vehicle's display, the user's terminal, or any combination thereof. In this way, the processor 110 may provide a user with information that may cause the user to use the battery control algorithm.

For example, a user may perceive the need to use the battery control algorithm by checking visual data associated with the battery condition displayed on the vehicle's display or the user's terminal.

According to an embodiment, the processor 110 may generate first information obtained by comparing information about a battery condition of the user with at least one of information about battery conditions of other users who employ the battery control algorithm, information about battery conditions of other users who do not employ the battery control algorithm, or any combination thereof.

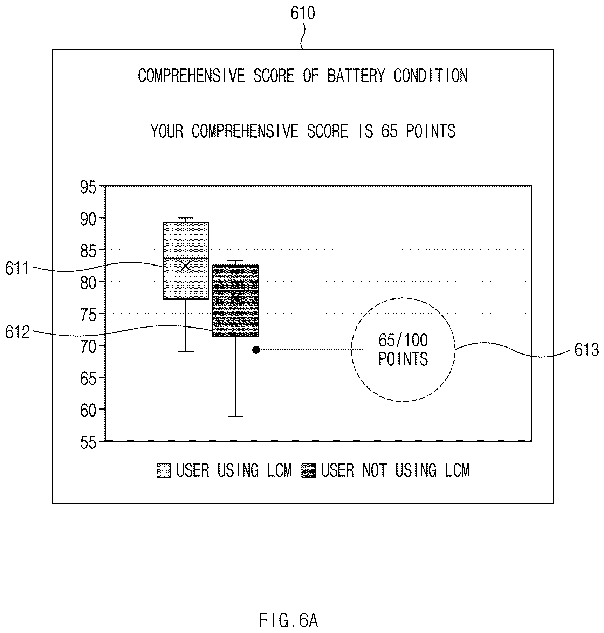

The first information generated by the processor 110, according to an embodiment, may include information described in more detail below with reference to FIG. 6A.

According to an embodiment, the first information may include information about a comprehensive score of the condition of the battery. In an embodiment, the comprehensive score may include a score calculated by synthesizing indicator-specific scores of battery conditions. The processor 110 may calculate the comprehensive score of the battery condition by using an average value, an indicator-specific weight, or the like.

In an embodiment, the information about battery conditions of other users employing the battery control algorithm may include information obtained by converting the battery conditions of other users employing the battery control algorithm into a score.

In an embodiment, the information about battery conditions of other users not employing the battery control algorithm may include information obtained by converting the battery conditions of other users not employing the battery control algorithm into a score.

According to an embodiment, the first information may include information about the user's battery condition. For example, the information about the user's battery condition may include information obtained by converting the user's battery condition into a score.

According to an embodiment, the processor 110 may generate, as the first information, information obtained by comparing a battery condition of a user with a battery condition of another user. In an embodiment, the battery conditions of other users may include information about another user who employs the battery control algorithm and another user who does not employ the battery control algorithm.

For example, the first information may include information about whether the user's battery condition is better or worse than that of another user.

If the user's battery condition is worse than that of another user, the user may feel the need to use the battery control algorithm based on the first information.

According to an embodiment, the processor 110 may generate the first information by using visual data. The visual data may include at least one of a graph, a chart, a diagram, or any combination thereof.

According to an embodiment, the processor 110 may display the first information generated as the visual data on at least one of a display of a vehicle, a terminal of a user, or any combination thereof.

According to an embodiment, the processor 110 may generate second information obtained by comparing, corresponding to one or more types of reference data, information about a battery condition of the user with at least one of information about battery conditions of other users who employ the battery control algorithm, information about battery conditions of other users who do not employ the battery control algorithm, or any combination thereof.

In an embodiment, one or more types of reference data may include at least one of the SOC of the battery, the SOH of the battery, the degradation rate of the battery, the cooling load of the battery, the charging load of the battery, data associated with thermal control of the battery, the power consumption efficiency of the battery, or any combination thereof.

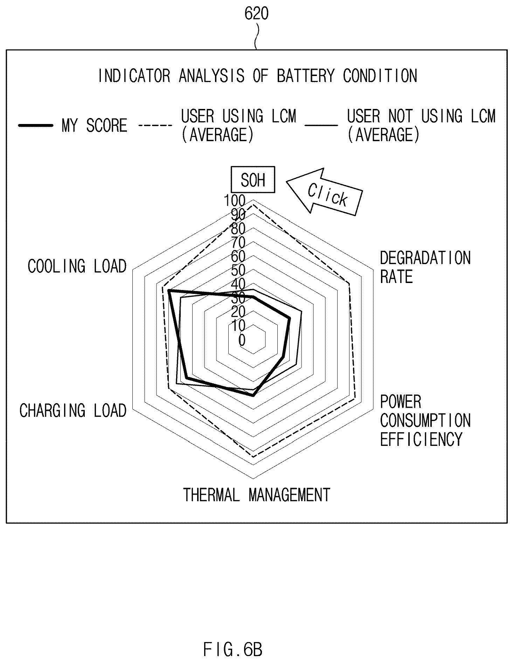

The second information generated by the processor 110, according to an embodiment, may include information described in more detail below with reference to FIG. 6B.

According to an embodiment, the second information may include information about a score calculated for respective types of reference data with respect to the condition of the battery. For example, the second information may include at least one of a score for the SOC of a battery, a score for the SOH of the battery, a score for the degradation rate of the battery, a score for the cooling load of the battery, a score for the charging load of the battery, a score for data associated with thermal control of the battery, a score for the power consumption efficiency of the battery, or any combination thereof.

According to an embodiment, the processor 110 may generate the second information obtained by comparing scores of batteries for the same respective type of reference data.

For example, the processor 110 may generate information for comparing the score for the cooling load of a user's battery, the score for the cooling load of batteries of other users that employ the battery control algorithm, and the score for the cooling load of batteries of other users that do not employ the battery control algorithm.

Based on the second information, a user may compare the condition of his/her battery with battery conditions of other users for respective types of reference data, and thus may feel the need to use the battery control algorithm.

According to an embodiment, the processor 110 may generate the second information in the form of visual data. The visual data may include at least one of a graph, a chart, a diagram, or any combination thereof.

According to an embodiment, the processor 110 may display the second information generated as the visual data on at least one of a display of a vehicle, a terminal of a user, or any combination thereof.

According to an embodiment, the processor 110 may generate third information about a user's battery condition corresponding to one among the one or more types reference data.

In an embodiment, the third information may include at least one of information about the battery condition of a user, information about battery conditions of multiple (e.g., all) users including the user, information about battery conditions of users other than the user, or any combination thereof.

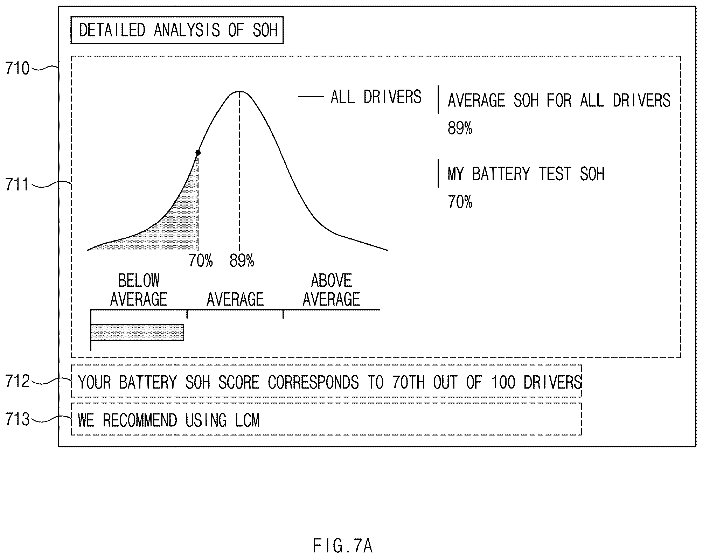

The third information generated by the processor 110, according to an embodiment, may include information described in more detail below with reference to FIG. 7A.

According to an embodiment, the third information may include information about specific reference data. For example, if the specific reference data is the SOH of a battery, the third information may include at least one of information about the SOH of a user, information about the SOH of batteries of all users including the user, information about the SOH of batteries of users other than the user, or any combination thereof.

According to an embodiment, the processor 110 may calculate information about specific reference data as a score. For example, if the specific reference data is the SOH of a battery, the third information may include the score for the SOH of the user's battery.

According to an embodiment, the processor 110 may calculate a score for the user's battery by specific reference data for the user's battery, and may compare the calculated score with scores for the batteries of multiple (e.g., all) users.

For example, if the specific reference data is SOH, the processor 110 may calculate the result of comparing the score for SOH of the user's battery with the scores for the SOH of batteries of all the users. In various embodiments, the compared result may be calculated as ranks, percentages, etc. For example, the processor 110 may calculate the result indicating that the SOH of the user's battery ranks 70th out of 100 users if the SOH of the user's battery is compared with the SOH of the batteries of multiple (e.g., all) users.

According to an embodiment, the processor 110 may generate the third information in the form of visual data. The visual data may include at least one of a graph, a chart, a diagram, or any combination thereof.

According to an embodiment, the processor 110 may display the third information generated as the visual data on at least one of a display of a vehicle, a terminal of a user, or any combination thereof.

According to an embodiment, the processor 110 may link the second information with the third information. For example, if specific reference data is selected from the second information, the third information about the selected reference data may be generated. As a concrete example, if a user selects SOH among the second information displayed on the display, the third information about the SOH may be displayed on a display.

According to an embodiment, the processor 110 may generate fourth information about a user's battery condition corresponding to one among the one or more types of reference data.

According to an embodiment, the fourth information may include at least one of information about a battery condition of the user, information about battery conditions of other users who employ a battery control algorithm, information about battery conditions of other users who do not employ the battery control algorithm, or any combination thereof.

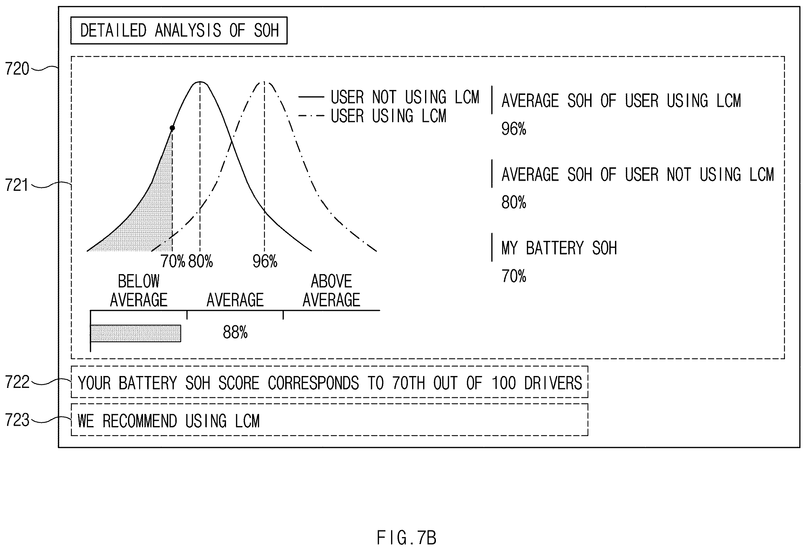

The fourth information generated by the processor 110, according to an embodiment, may include information described in more detail below with reference to FIG. 7B.

According to an embodiment, the fourth information may include information about specific reference data. For example, if the specific reference data is the SOH of the battery, the fourth information may include at least one of information about the SOH of the user's battery, information about the SOH of batteries of other users that employ the battery control algorithm, information about the SOH of batteries of other users that do not employ the battery control algorithm, or any combination thereof.

According to an embodiment, the processor 110 may calculate information about specific reference data as a score. For example, if the specific reference data is the SOH of a battery, the fourth information may include the score for the SOH of the user's battery.

According to an embodiment, the processor 110 may calculate a score for the user's battery by specific reference data for the user's battery, and may compare the calculated score with at least one of a score for batteries of other users who employ the battery control algorithm, a score for batteries of other users who do not employ the battery control algorithm, or any combination thereof.

For example, if the specific reference data is SOH, the processor 110 may calculate the result of comparing the score for SOH of the user's battery with the score for SOH of batteries of other users who employ the battery control algorithm. In various embodiments, the compared result may be calculated as ranks, percentages, etc.

According to an embodiment, the processor 110 may generate the fourth information in the form of visual data. The visual data may include at least one of a graph, a chart, a diagram, or any combination thereof.

According to an embodiment, the processor 110 may display the fourth information generated as the visual data on at least one of a display of a vehicle, a terminal of a user, or any combination thereof.

According to an embodiment, the processor 110 may link the second information with the fourth information. For example, if specific reference data is selected from the second information, the fourth information about the selected reference data may be generated. As a concrete example, if a user selects SOH among the second information displayed on the display, the fourth information about the SOH may be displayed on a display.

According to an embodiment, the processor 110 may generate fifth information obtained by comparing first data converted into a predetermined indicator with second data converted into a predetermined indicator, for one or more types of reference data. In an embodiment, the one or more types of reference data may include at least one of the SOC of the battery, the SOH of the battery, the degradation rate of the battery, the cooling load of the battery, the charging load of the battery, data associated with thermal control of the battery, the power consumption efficiency of the battery, or any combination thereof.

According to an embodiment, the fifth information may include information about a score calculated for respective reference data with respect to the condition of the battery. For example, the fifth information may include at least one of a score for the SOC of a battery, a score for the SOH of the battery, a score for the degradation rate of the battery, a score for the cooling load of the battery, a score for the charging load of the battery, a score for data associated with thermal control of the battery, a score for the power consumption efficiency of the battery, or any combination thereof.

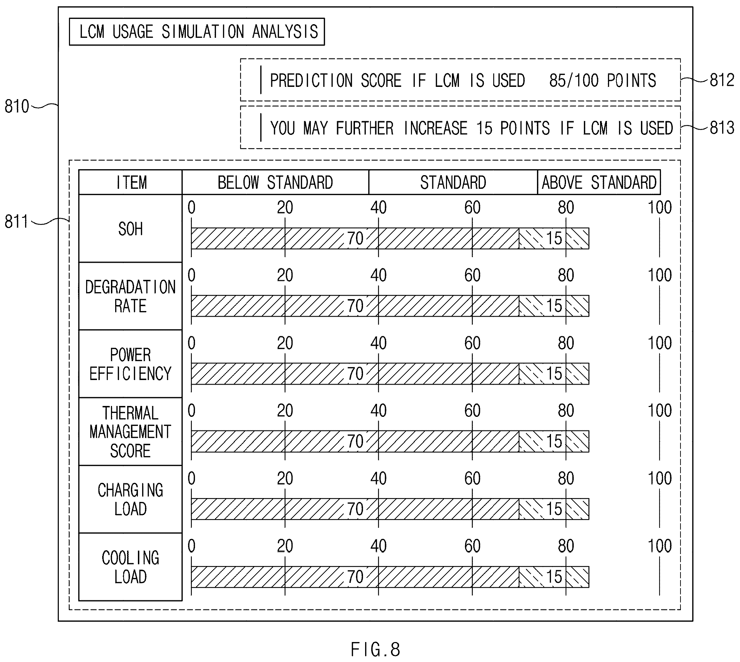

The fifth information generated by the processor 110, according to an embodiment, may include information described in more detail below with reference to FIG. 8.

According to an embodiment, the processor 110 may determine whether a score calculated for reference data is less than or equal to a standard, equal to the standard, or greater than or equal to the standard. In an embodiment, the standard may include a reference value corresponding to the average value of multiple (e.g., all) users.

According to an embodiment, the fifth information may include information about a difference between the first data and the second data. For example, the processor 110 may calculate the difference between the first data and the second data by reference data. As a concrete example, the processor 110 may calculate the difference between the remaining capacity of a battery using the battery control algorithm and the remaining capacity of a battery not using the battery control algorithm. In this case, the remaining capacity of a battery using the battery control algorithm may be calculated to be higher.

According to an embodiment, the fifth information may include a numerical value for the difference between the first data and the second data. For example, the processor 110 may calculate the difference between the remaining capacity of a battery using the battery control algorithm and the remaining capacity of a battery not using the battery control algorithm.

According to an embodiment, the fifth information may include a reference data-specific score of the expected battery condition if the battery control algorithm is used. For example, if the current user is in a state where the battery control algorithm is not being used, the fifth information may include a score for the battery condition expected if the battery control algorithm is being used.

According to an embodiment, the fifth information may include information associated with a change in the reference data-specific score of the condition of a battery using the battery control algorithm. For example, the fifth information may include information about how much the score for the battery condition may increase if the battery control algorithm is used.

According to an embodiment, the processor 110 may generate the fifth information in the form of visual data. The visual data may include at least one of a graph, a chart, a diagram, or any combination thereof.

According to an embodiment, the processor 110 may display the fifth information generated as the visual data on at least one of a display of a vehicle, a terminal of a user, or any combination thereof.

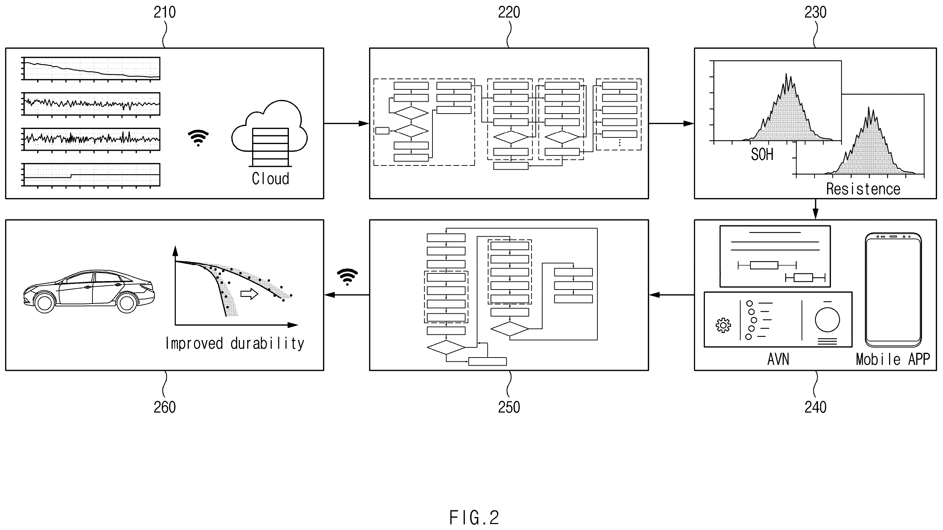

FIG. 2 is a diagram showing an example of a process in which a battery control algorithm is applied to a vehicle battery by a battery diagnosing apparatus, according to an embodiment of the present disclosure.

Referring to FIG. 2 according to an embodiment, a process of applying a battery control algorithm to a battery of a vehicle may include process 210 of collecting and preprocessing data, process 220 of precisely diagnosing a condition of the battery, process 230 of analyzing data associated with the condition of the battery, process 240 of providing a user with information that may cause the user to use the battery control algorithm, process 250 of setting a specific control strategy of the battery control algorithm, and process 260 of applying the battery control algorithm to the battery.

According to an embodiment, process 210 of collecting and preprocessing data may include a process of collecting data associated with a vehicle and data associated with a battery, and refining the collected data.

According to an embodiment, process 220 of precisely diagnosing a condition of the battery may include a process for diagnosing the condition of the battery by using battery data, a parameter calculated based on the battery data, and data associated with the condition of the battery.

According to an embodiment, process 230 of analyzing data associated with the condition of the battery may include a process for analyzing the condition of the user's battery based on data associated with the condition of the battery. For example, process 230 may include a process of comparing and analyzing the condition of the user's battery with that of a battery included in the same vehicle model.

According to an embodiment, process 240 of providing a user with information that may cause the user to use the battery control algorithm may include a process of displaying information about the condition of the battery on a display of a vehicle or the user's terminal.

According to an embodiment, process 250 of setting a specific control strategy of the battery control algorithm may include a process of setting the battery control algorithm where the user's battery may be being optimized.

According to an embodiment, process 260 of applying the battery control algorithm to the battery may include a process in which a battery of the vehicle is controlled according to the battery control algorithm if the user employs the battery control algorithm.

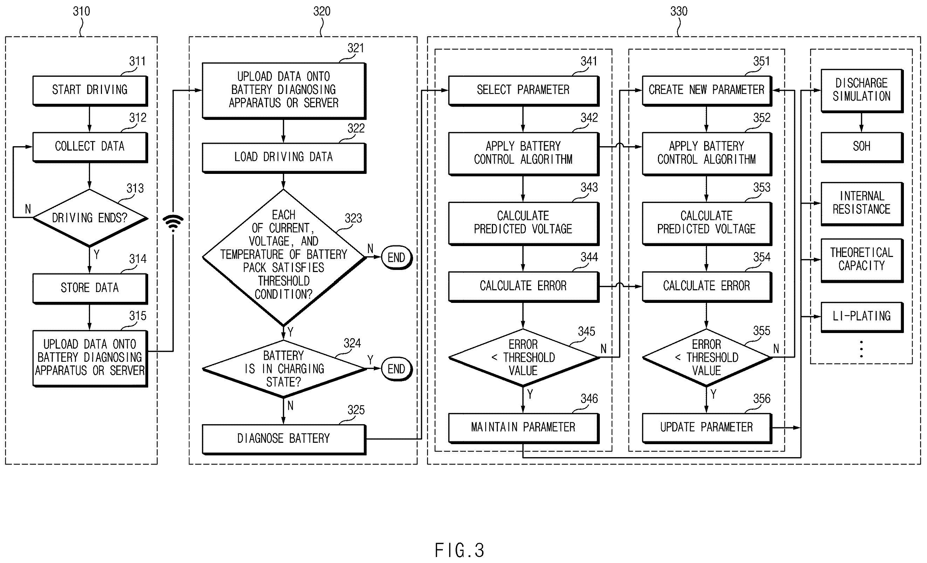

FIG. 3 is a diagram showing a process in which a battery diagnosing apparatus identifies a parameter from battery data to diagnose a battery, according to an embodiment of the present disclosure.

Referring to FIG. 3,a process in which a battery diagnosing apparatus identifies a parameter from battery data to diagnose a battery, according to an embodiment, may include process 310 for collecting data, process 320 for preprocessing the collected data, and process 330 for diagnosing a condition of the battery.

For example, each process may be executed by at least one processor.

For example, each process may be executed by a same processor.

As another example, each process may be executed by a different processor.

As an example, process 310 for collecting data may be performed by a first processor, process 320 for preprocessing the collected data may be performed by a second processor, and process 330 for diagnosing a battery condition may be performed by a third processor.

According to an embodiment, in an operation a vehicle may start driving. In an operation 312, the first processor may collect at least one of data associated with the vehicle, data associated with the battery, or any combination thereof. In an operation 313, the first processor may determine whether the vehicle's driving ends. If the vehicle's driving is finished, in an operation 314, the first processor may store the collected data. In an embodiment, the collected data may be stored in a memory or a database. In an operation 315, the first processor may upload data onto the battery diagnosing apparatus or a server.

According to an embodiment, the first processor may upload data onto the battery diagnosing apparatus or the server via wireless communication in an operation 321. The second processor may load driving data in an operation 322. In an operation 323, the second processor may determine whether each of the current of a battery pack, the voltage of the battery pack, and the temperature of the battery pack satisfies a threshold condition. If each of the current of the battery pack, the voltage of the battery pack, and the temperature of the battery pack satisfies the threshold condition, the second processor may determine whether the battery is in a charging state in an operation 324. In an operation 325, the second processor may diagnose the battery if the battery is not charging.

According to an embodiment, the third processor may select a parameter in an operation 341. For example, as the battery ages, the structure or state of an internal electrode of the battery may change. The third processor may select the appropriate parameter for reflecting the change in the condition of the battery.

For example, the third processor may select the parameter including at least one of internal resistance, diffusion coefficient, reaction rate constant, porosity, or any combination thereof. For example, the third processor may identify the parameter via electrochemical experiments or data in the initial state of the battery.

According to an embodiment, in an operation 342, the third processor may apply a battery control algorithm based on the selected parameter.

According to an embodiment, the battery control algorithm may include a high-voltage battery model. For example, the battery control algorithm may include predetermined electrochemical models. In an embodiment, the battery control algorithm may include at least one of a Pseudo-two-dimensional (P2D) model, a single particle model (SPM), a SPM with electrolyte (SPMe), or any combination thereof.

According to an embodiment, in an operation 343, the third processor may calculate a predicted voltage. For example, the third processor may calculate the predicted voltage by using voltage prediction simulation.

For example, the third processor may predict the voltage by using at least one of an existing parameter, a measured current, a temperature profile, or any combination thereof.

According to an embodiment, in an operation 344, the third processor may calculate the error of the voltage or current. For example, the third processor may calculate the root mean square error for the voltage by using the predicted voltage and the measured voltage. As a concrete example, the third processor may calculate the root mean square error for voltage by using at least one of the predicted voltage, the measured voltage, the length of data, an electrochemical parameter, or any combination thereof.

According to an embodiment, in an operation 345, the third processor may determine whether the error is less than a threshold value.

According to an embodiment, if the error is less than or equal to the threshold value, the third processor may maintain the existing parameter in an operation 346.

According to an embodiment, in an operation 351, the third processor may create a new parameter if the error is greater than the threshold value.

According to an embodiment, in an operation 352, the third processor may apply a battery control algorithm based on the new parameter.

According to an embodiment, in an operation 353, the third processor may calculate the predicted voltage based on the new parameter.

According to an embodiment, in an operation 354, the third processor may calculate the error of the voltage or current based on the new parameter.

According to an embodiment, in an operation 355, the third processor may determine whether the error based on the new parameter is less than the threshold value.

According to an embodiment, in an operation 356, the third processor may update the parameter if the error based on the new parameter is less than or equal to the threshold value.

According to an embodiment, the third processor may generate another new parameter again if the error based on the new parameter is greater than the threshold value in the operation 351.

According to an embodiment, if the existing parameter is maintained or updated so as to be changed to a new parameter, the third processor may identify a final parameter. For example, the final parameters may include SOH, internal resistance, theoretical capacity, and Li-plating calculated via discharge simulation.

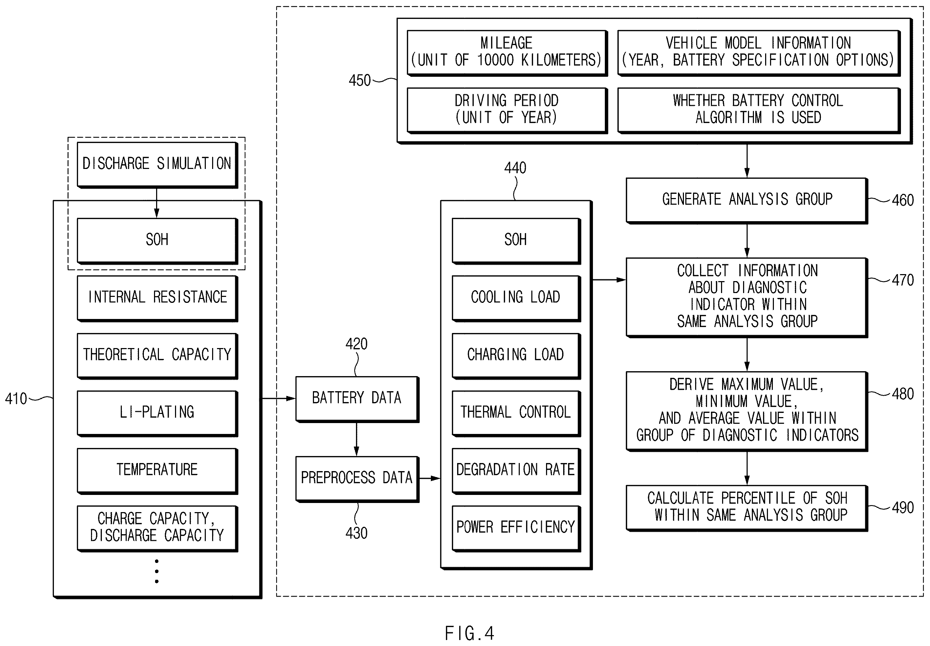

FIG. 4 is a diagram showing a process in which a battery diagnosing apparatus analyzes data associated with a condition of a battery based on a parameter, according to an embodiment of the present disclosure.

According to an embodiment, in an operation 410, a battery diagnosing apparatus may identify a parameter. For example, the parameter may include at least one of SOH, internal resistance, theoretical capacity, Li-plating, temperature, charge capacity, discharge capacity, or any combination thereof, calculated using discharge simulation.

According to an embodiment, in an operation 420, the battery diagnosing apparatus may collect battery data based on the identified parameter.

According to an embodiment, in an operation 430, the battery diagnosing apparatus may perform data preprocessing on the collected battery data.

According to an embodiment, in an operation 440, the battery diagnosing apparatus may identify a diagnostic indicator based on the battery data. The diagnostic indicator may include data associated with a battery condition. For example, the diagnostic indicator may include at least one of SOH, cooling load, charging load, data associated with thermal control, degradation rate, power efficiency (power consumption efficiency), or any combination thereof.

According to an embodiment, in an operation 450, the battery diagnosing apparatus may identify data associated with a vehicle. For example, the data associated with a vehicle may include information about at least one of the mileage of the vehicle, the model of the vehicle, the driving period of the vehicle, whether a battery control algorithm is used, or any combination thereof.

According to an embodiment, in an operation 460, the battery diagnosing apparatus may generate an analysis group based on the data associated with the vehicle.

According to an embodiment, in an operation 470, the battery diagnosing apparatus may collect information about a diagnostic indicator within the same analysis group.

According to an embodiment, in an operation 480, the battery diagnosing apparatus may derive a maximum value, a minimum value, and an average value of data associated with a condition of a battery within a group of diagnostic indicators.

According to an embodiment, in an operation 490, the battery diagnosing apparatus may calculate the percentile of SOH within the same analysis group.

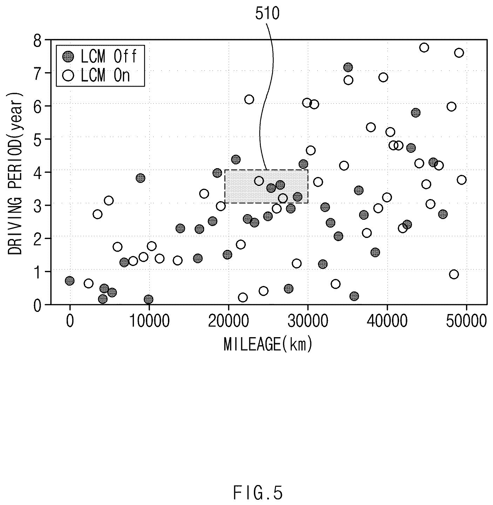

FIG. 5 is a distribution diagram of batteries to which a battery control algorithm is applied and batteries, to which the battery control algorithm is not applied, according to a driving period of a vehicle and a mileage of the vehicle, according to an embodiment. The distribution diagram may be generated by a battery diagnosing apparatus, according to an embodiment.

According to an embodiment, a battery diagnosing apparatus may generate a distribution diagram of batteries to which a battery control algorithm is applied, and batteries to which the battery control algorithm is not applied. In an embodiment, the battery control algorithm may include LCM.

According to an embodiment, batteries to which a battery control algorithm is applied and batteries to which the battery control algorithm is not applied may be classified according to an analysis group. For example, the analysis group may include an analysis group classified based on a vehicle's driving period and vehicle mileage.

The distribution diagram of FIG. 5 according to an embodiment may include an X-axis for mileage and a Y-axis for driving period.

According to an embodiment, a first analysis group may include batteries with a mileage of 20,000 km or more and 30,000 km or less, and a driving period of 3 years or more and 4 years or less.

According to an embodiment, the battery diagnosing apparatus may identify a battery to which a battery control algorithm is applied and a battery to which the battery control algorithm is not applied. The batteries are included in the first analysis group.

For example, referring to FIG. 5, the first analysis group may include two batteries to which the battery control algorithm is applied and three batteries to which the battery control algorithm is not applied.

Referring to FIG. 5, according to an embodiment, the battery diagnosing apparatus may classify data associated with a battery condition according to the analysis group.

FIG. 6A is a diagram showing an example of a comprehensive score of a battery condition displayed on a display by a battery diagnosing apparatus, according to an embodiment of the present disclosure.

According to an embodiment, a battery diagnosing apparatus may display information 610 about a comprehensive score of the condition of a battery on at least one of a display of a vehicle, a terminal of a user, or any combination thereof.

According to an embodiment, the information 610 about the comprehensive score for the condition of the battery displayed on the display may include information about a score 611 of a battery of a user employing LCM and a score 612 of a battery of a user not employing LCM.

According to an embodiment, the information 610 about the comprehensive score for the condition of the battery displayed on the display may include a score 613 for the condition of the user's battery.

Referring to FIG. 6A, according to an embodiment, a user may compare the condition of a battery employed by the user with the condition of a battery employed by other users based on the information 610 about the comprehensive score for the condition of the battery displayed on the display.

FIG. 6B is a drawing showing an example of an indicator-specific score of a battery condition displayed on a display by a battery diagnosing apparatus, according to an embodiment of the present disclosure.

According to an embodiment, a battery diagnosing apparatus may display information 620 about an indicator-specific score of the condition of a battery on at least one of a display of a vehicle, a terminal of a user, or any combination thereof. For example, the indicator score may include an average score.

According to an embodiment, the information 620 about the indicator-specific score of the condition of the battery may include an indicator-specific score of the condition of a battery of a user.

According to an embodiment, the information 620 about the indicator-specific score of the condition of the battery may include an indicator-specific score of the condition of the battery of another user employing LCM.

According to an embodiment, the information 620 about the indicator-specific score of the condition of the battery may include an indicator-specific score of the condition of the battery of another user who does not employ LCM.

According to an embodiment, the indicator of the condition of the battery may include at least one of SOH, degradation rate, power consumption efficiency, thermal management, charging load, cooling load, or any combination thereof, of a battery.

Referring to FIG. 6B, according to an embodiment, the battery diagnosing apparatus may display the information 620 about the indicator-specific score of the condition of the battery in the form of a chart. For example, the battery diagnosing apparatus may display the indicator-specific score via a radar chart or a spider chart.

According to an embodiment, the radar chart or the spider chart may include a chart that visually displays comparisons between items by radially displaying numerical values of a plurality of items.

According to an embodiment, the user may check detailed analysis results for the specific indicator by selecting a specific indicator among the information 620 on the indicator-specific score of the battery condition displayed on the display.

Referring to FIG. 6B, according to an embodiment, if the user wants to check the detailed analysis results for SOH, the user may click SOH among the information 620 for the indicator-specific score of the condition of the battery displayed on the display.

FIG. 7A is a drawing showing an example of a result of comparing the SOH of a battery used by a user and batteries used by multiple (e.g., all) users, that may be displayed on a display by a battery diagnosing apparatus, according to an embodiment of the present disclosure.

Referring to FIG. 7A, according to an embodiment, a battery diagnosing apparatus may display first information 710 about detailed analysis results of the SOH on at least one of a display of a vehicle, a terminal of a user, or any combination thereof.

For example, the first information 710 about the result of detailed analysis of SOH may include information 711 about the result of comparing the SOH of the battery used by the user with batteries used by multiple (e.g., all) users, information 712 about the ranking according to the score of the user's SOH, and information 713 about whether use of a battery control algorithm is recommended.

As a concrete example, the information 711 about the result of comparing the SOH of the battery used by the user with the batteries used by multiple (e.g., all) users may include information about the average SOH of the batteries of multiple (e.g., all) users and the SOH of the user's battery.

As a concrete example, the information 712 about the ranking according to the user's SOH score may be expressed as "rank 'n' out of 100" by converting the user's SOH score into a percentage.

Referring to FIG. 7A, according to an embodiment, the average SOH of multiple (e.g., all) users may be identified as 89%, while the SOH of the user's battery may be identified as 70%. Accordingly, the battery diagnosing apparatus may determine that the SOH of the user's battery corresponds to the 70th out of 100 users. In an embodiment, the battery diagnosing apparatus may recommend the use of LCM based on the SOH of the user's battery being lower than the average SOH of multiple (e.g., all) users.

FIG. 7B is a drawing showing an example of the results of analyzing the SOH of a battery according to whether LCM is used, that may be displayed on a display by a battery diagnosing apparatus, according to an embodiment of the present disclosure.

Referring to FIG. 7B, according to an embodiment, a battery diagnosing apparatus may display second information 720 about detailed analysis results of the SOH on at least one of a display of a vehicle, a terminal of a user, or any combination thereof.

For example, the second information 720 about the result of detailed analysis of SOH may include information 721 about the result of analyzing SOH of the battery according to whether LCM is used, information 722 about the ranking according to the score of the user's SOH, and information 723 about whether use of a battery control algorithm is recommended.

As a concrete example, the information 721 about the result of comparing the SOH of the battery used by the user with batteries used by multiple (e.g., all) users may include information about the SOH of the user, the average SOH of the batteries of other users who use LCM, and the average SOH of the batteries of other users who do not use LCM.

As a concrete example, the information 722 about the ranking according to the user's SOH score may be expressed as "rank 'n' out of 100" by converting the user's SOH score into a percentage.

Referring to FIG. 7B, according to an embodiment, the average SOH of the battery of another user using LCM may be identified as 96%, the average SOH of the battery of another user not using LCM may be identified as 80%, while the SOH of the user may be identified as 70%. Accordingly, the battery diagnosing apparatus may determine that the SOH of the user's battery corresponds to the 70th out of 100 users. In an embodiment, the battery diagnosing apparatus may recommend the use of LCM based on the SOH of the user's battery being lower than the average SOH of batteries of other users who use LCM.

FIG. 8 is a drawing showing an example of an indicator-specific score of a battery condition expected if LCM is used, that may be displayed on a display by a battery diagnosing apparatus, according to an embodiment of the present disclosure.

According to an embodiment, a battery diagnosing apparatus may display information 810 about an indicator-specific score of the condition of a battery, that is expected if LCM is used, on at least one of a display of a vehicle, a terminal of a user, or any combination thereof.

According to an embodiment, the information 810 about an indicator-specific score of the condition of a battery, that is expected if LCM is used, may include a graph 811 associated with the indicator-specific score of the battery condition of a user who does not use LCM and the indicator-specific score of the battery condition expected if LCM is used, a score 812 expected if LCM is used, and information 813 about the score that increases if LCM is used.

According to an embodiment, indicators of the battery condition may include SOH, degradation rate, power efficiency (power consumption efficiency), thermal management, charging load, cooling load, or any combination thereof.

Referring to FIG. 8, according to an embodiment, the indicator-specific score of the battery condition of a user who does not use LCM may be identified as 70 points. However, this is only an example. The indicator-specific scores may vary.

Referring to FIG. 8, according to an embodiment, a score predicted if a user uses LCM may be determined to be 85 points. The battery diagnosing apparatus may display information indicating that a user's battery condition may increase by 15 points if the user employs LCM, based on the indicator-specific score of the battery condition of a user who does not employ LCM being identified as 70 points.

Referring to FIG. 8, according to an embodiment, the battery diagnosing apparatus may provide a user with information that may cause a user to use LCM, by providing the user with an indicator-specific score of a battery condition expected if the LCM is used.

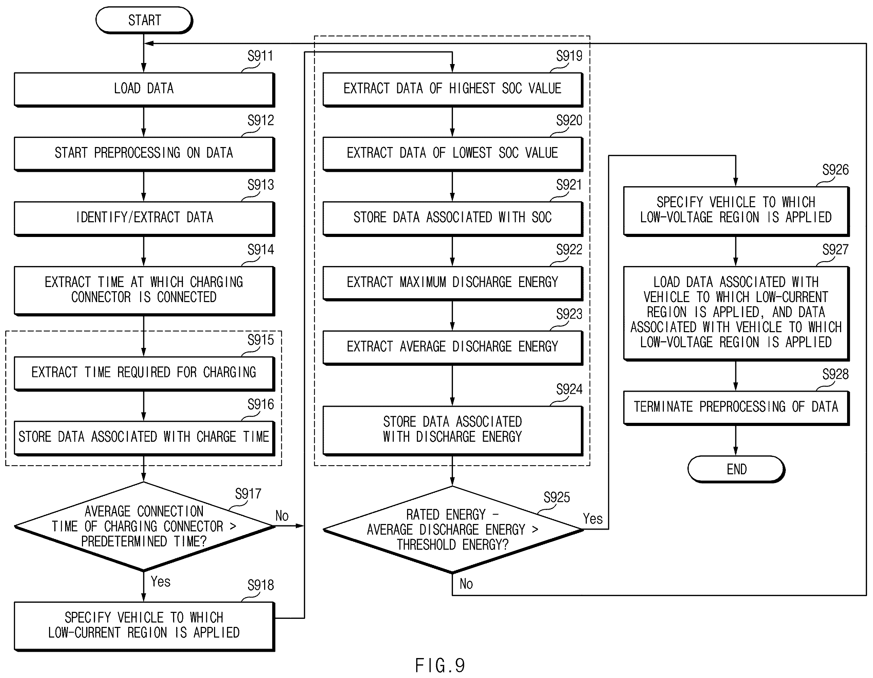

FIG. 9 is a flowchart showing an example of a data preprocessing process performed by a battery diagnosing apparatus, according to an embodiment of the present disclosure.

According to an embodiment, in an operation S911, a battery diagnosing apparatus may load at least one of data associated with a battery, data associated with a vehicle, or any combination thereof.

According to an embodiment, in an operation S912, the battery diagnosing apparatus may perform preprocessing on the loaded data.

According to an embodiment, in an operation S913, the battery diagnosing apparatus may identify data or may extract data.

According to an embodiment, in an operation S914, the battery diagnosing apparatus may extract the time at which a charging connector is connected to a battery. For example, the battery diagnosing apparatus may extract the total time during which the charger connector is connected to the battery, regardless of whether the battery is charging.

According to an embodiment, in an operation S915, the battery diagnosing apparatus may extract the time required for the battery to be charged.

According to an embodiment, in an operation S916, the battery diagnosing apparatus may store data associated with a charge time.

According to an embodiment, in an operation S917, the battery diagnosing apparatus may determine whether the average connection time of the charging connector is greater than a predetermined time. For example, the predetermined time may be set based on an average charge time and a weight. As a concrete example, the predetermined time may be set to the value of "average charge time * weight".

According to an embodiment, if the average connection time of the charging connector is greater than the predetermined time, in an operation S918, the battery diagnosing apparatus may specify a vehicle to which a low-current region is applied.

According to an embodiment, in an operation S919, the battery diagnosing apparatus may specify the vehicle to which a low-current region is applied, and may extract data of the highest SOC value.

According to an embodiment, if the average connection time of the charging connector is less than or equal to the predetermined time, the battery diagnosing apparatus may extract data of the highest SOC value without specifying the vehicle to which a low-current region is applied in the operation S919.

According to an embodiment, in an operation S902, the battery diagnosing apparatus may extract data of the lowest SOC value.

According to an embodiment, in an operation S921, the battery diagnosing apparatus may store data associated with SOC.

According to an embodiment, in an operation S922, the battery diagnosing apparatus may extract maximum discharge energy.

According to an embodiment, in an operation S923, the battery diagnosing apparatus may extract average discharge energy.

According to an embodiment, in an operation S924, the battery diagnosing apparatus may extract data associated with discharge energy.

According to an embodiment, in an operation S925, the battery diagnosing apparatus may determine whether a value obtained by subtracting average energy from rated energy is greater than threshold energy.

According to an embodiment, if the value obtained by subtracting the average energy from the rated energy is not greater than the threshold energy, the battery diagnosing apparatus may return to the operation 911 of loading data.

According to an embodiment, if the value obtained by subtracting the average energy from the rated energy is greater than the threshold energy, in an operation S926, the battery diagnosing apparatus may specify a vehicle to which a low-voltage region is applied.

According to an embodiment, in an operation S927, the battery diagnosing apparatus may load data associated with the vehicle to which the low-current region is applied, and data associated with the vehicle to which a low-voltage region is applied. For example, the battery diagnosing apparatus may load data associated with a charge time for the vehicle to which a low-current region is applied. As another example, the battery diagnosing apparatus may load data associated with discharge energy for the vehicle to which a low-voltage region is applied.

According to an embodiment, in an operation S928, the battery diagnosing apparatus may analyze data associated with the vehicle to which a low-current region is applied, and data associated with the vehicle to which a low-voltage region is applied, and may terminate preprocessing of data.

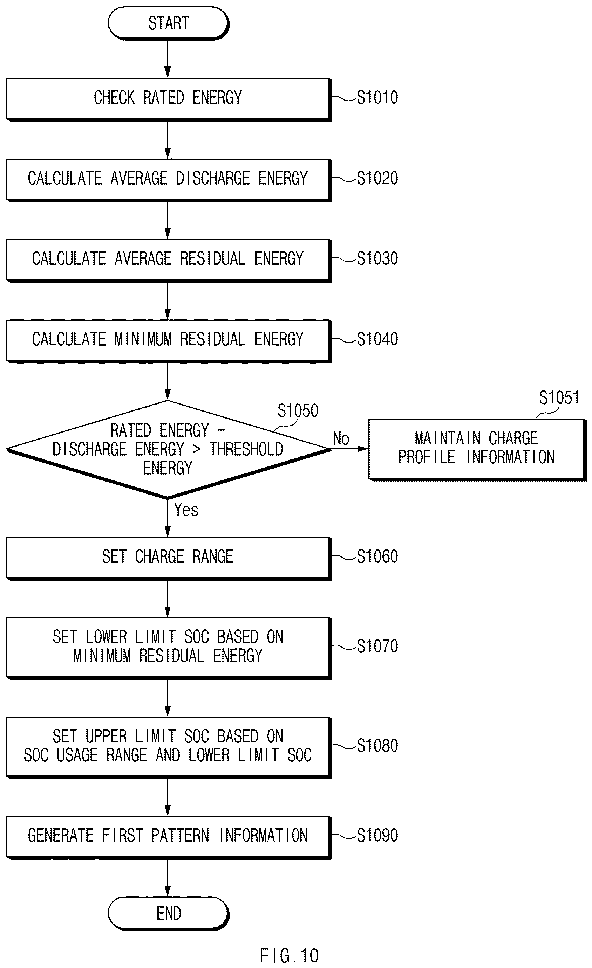

FIG. 10 is a flowchart showing an example of generating first pattern information during a data preprocessing process performed by a battery diagnosing apparatus, according to an embodiment of the present disclosure.

According to an embodiment, each of the operations in FIG. 10 may be performed sequentially, but is not necessarily sequentially performed. For example, the order of operations may be changed, and at least two operations may be performed in parallel.

In an operation S1010, 1 battery diagnosing apparatus according to an embodiment may check rated energy of a battery.

In an operation S1020, the battery diagnosing apparatus according to an embodiment may calculate average discharge energy of the battery. The battery diagnosing apparatus may calculate the average discharge energy of the battery by repeatedly identifying discharge energy of the battery.

In an operation S1030, the battery diagnosing apparatus according to an embodiment may calculate average residual energy. The battery diagnosing apparatus may calculate the average residual energy by repeatedly identifying residual energy.

In an operation S1040, the battery diagnosing apparatus according to an embodiment may calculate minimum residual energy.

In an operation S1050, the battery diagnosing apparatus according to an embodiment may determine whether a difference between rated energy and discharge energy exceeds threshold energy. For example, the battery diagnosing apparatus may determine whether a difference between rated SOC corresponding to rated energy and an SOC usage range corresponding to discharge energy exceeds threshold SOC (e.g., about 30%). If the difference between the rated SOC and the SOC usage range does not exceed the threshold SOC (No in the operation S1050), the battery diagnosing apparatus according to an embodiment may maintain charge profile information in an operation S1051.

If the difference between the rated SOC and the SOC usage range exceeds the threshold SOC (Yes in the operation S1050), the battery diagnosing apparatus according to an embodiment may set a charge range in an operation S1060. The battery diagnosing apparatus may set the charge range of the battery by using at least one of the rated energy, the average discharge energy, the average residual energy, the minimum residual energy, or any combination thereof.

In an operation S1070, the battery diagnosing apparatus according to an embodiment may set lower limit SOC based on the minimum residual energy.

In an operation S1080, the battery diagnosing apparatus according to an embodiment may set maximum SOC (or upper limit SOC) based on a SOC usage range and the lower limit SOC. For example, the upper limit SOC may represent a value obtained by adding the SOC usage range corresponding to the discharge energy to the lower limit SOC. The upper limit SOC may be used to limit the charge capacity of a battery if the battery is charged. The battery diagnosing apparatus may set the charge range for charging the battery up to the upper limit SOC.

In an operation S1090, the battery diagnosing apparatus according to an embodiment may generate first pattern information based on setting the charge range. For example, the battery diagnosing apparatus may update the charge profile information based on the first pattern information. If the battery is charged depending on the charge profile information updated based on the first pattern information, the battery may be charged such that the battery's SOC is included in the set charge range.

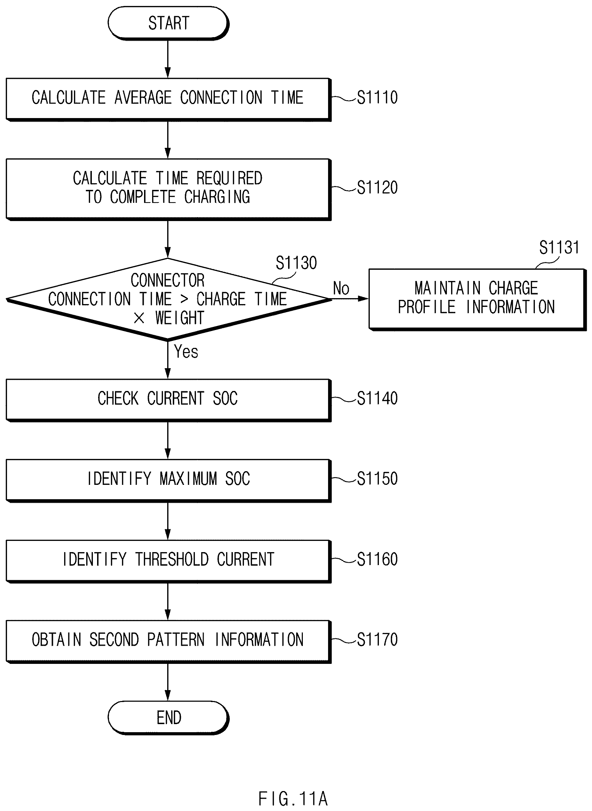

FIG. 11A is a flowchart showing an example of obtaining second pattern information during a data preprocessing process performed by a battery diagnosing apparatus, according to an embodiment of the present disclosure.

In an operation S1110, a battery diagnosing apparatus according to an embodiment may calculate an average connection time. The battery diagnosing apparatus may calculate the connection time to a charging connector (or charger).

In an operation S1120, the battery diagnosing apparatus according to an embodiment may calculate the time required to complete charging of a battery by identifying a charge time representing a time point at which charging of the battery is started using a charging connector, to a time point at which charging of the battery is completed.

In an operation S1130, the battery diagnosing apparatus according to an embodiment may determine whether a value obtained by multiplying the charge time by a weight (e.g., 1.5) exceeds a connection time. If the value obtained by multiplying the charge time by the weight (e.g., 1.5) does not exceed the connection time (No in the operation S1130), the battery diagnosing apparatus may maintain charge profile information in an operation S1131. On the other hand, if the value obtained by multiplying the charge time by the weight (e.g., 1.5) exceeds the connection time (Yes in the operation S1130), the battery diagnosing apparatus may check the current SOC of the battery in an operation S1140.

In an operation S1150, the battery diagnosing apparatus according to an embodiment may identify maximum SOC. The battery diagnosing apparatus may identify the maximum SOC by using rated energy, discharge energy, residual energy, and/or minimum residual energy. The maximum SOC may represent the upper limit SOC for charging the battery. For example, the maximum SOC may correspond to the rated energy. For example, the maximum SOC may represent a value obtained by adding the SOC usage range corresponding to the discharge energy to the lower limit SOC. However, an embodiment is not limited thereto.

In an operation S1160, the battery diagnosing apparatus according to an embodiment may identify a threshold current. The threshold current may represent the upper limit value of the charge current to be transmitted to the battery.

In an operation S1170, the battery diagnosing apparatus according to an embodiment may obtain second pattern information based on identifying the threshold current. The battery diagnosing apparatus may update charge profile information by using the second pattern information. The battery diagnosing apparatus may adjust the charge current based on the threshold current if charging the battery according to the updated charge profile information.

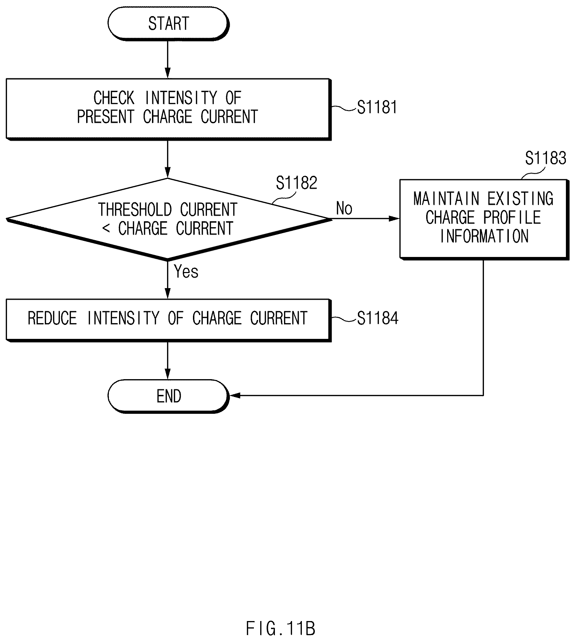

FIG. 11B is a flowchart showing a detailed example of obtaining second pattern information during a data preprocessing process performed by a battery diagnosing apparatus, according to an embodiment of the present disclosure.

In an operation S1181, a battery diagnosing apparatus according to an embodiment may check the intensity of a present charge current if charging a battery via a charging connector.

In an operation S1182, the battery diagnosing apparatus may determine whether a threshold current is less than the charge current. If the threshold current is greater than the charge current (No in the operation S1182), the battery diagnosing apparatus may maintain charge profile information in an operation S1183. The battery diagnosing apparatus may charge the battery according to the maintained charge profile information by maintaining the charge profile information without updating the charge profile information based on the second pattern information.

If the threshold current is less than the charge current (Yes in the operation S1182), the battery diagnosing apparatus according to an embodiment may reduce the intensity of the charge current in an operation S1184. The battery diagnosing apparatus may control the intensity of the charge current to be less than or equal to the threshold current.

A battery diagnosing apparatus and a battery diagnosing method, according to embodiments of the present disclosure, are described in more detail herein below.

According to an aspect, a battery diagnosing method includes identifying, by a processor, at least one of first battery data for a battery to which a battery control algorithm associated with control of a battery is applied, second battery data for a battery to which the battery control algorithm is not applied, or any combination thereof. The battery diagnosing method also includes generating, by the processor, information about a condition of the battery based on at least one of the first battery data, the second battery data, or any combination thereof.

The battery diagnosing method according to an embodiment may further include identifying, by the processor, at least one of at least one first parameter calculated based on the first battery data, at least one second parameter calculated based on the second battery data, or any combination thereof. The battery diagnosing method may also include calculating, by the processor, at least one of first data associated with the condition of the battery based on the at least one first parameter, second data associated with the condition of the battery based on the at least one second parameter, or any combination thereof.

According to an embodiment, generating the information about the condition of the battery may include generating the information about the condition of the battery based on at least one of the first data, the second data, or any combination thereof.

According to an embodiment, generating the information about the condition of the battery may include generating the information about the condition of the battery to include information obtained by comparing a first state of the battery according to the first data with a second state of the battery according to the second data.

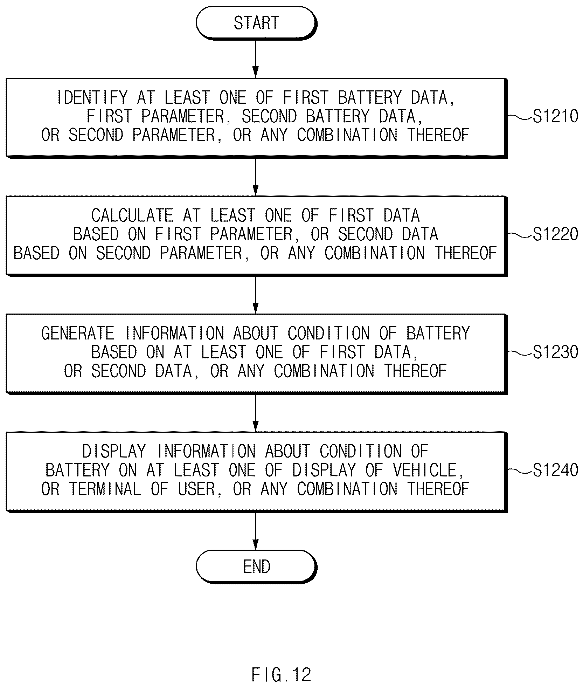

FIG. 12 is a flowchart for describing a battery diagnosing apparatus or a battery diagnosing method, according to an embodiment of the present disclosure.

Hereinafter, the battery diagnosing apparatus 100 of FIG. 1 may perform the process of FIG. 12. In addition, in the description of FIG. 12, it may be understood that an operation described as being performed by a battery diagnosing apparatus is controlled by the processor 110 of the battery diagnosing apparatus 100.

According to an embodiment, in an operation S1210, the battery diagnosing apparatus may identify at least one of first battery data, a first parameter, second battery data, a second parameter, or any combination thereof.

According to an embodiment, in an operation S1220, the battery diagnosing apparatus may calculate at least one of first data based on the first parameter, second data based on the second parameter, or any combination thereof.

According to an embodiment, in an operation S1230, the battery diagnosing apparatus may generate information about the condition of a battery based on at least one of the first data, the second data, or any combination thereof.

According to an embodiment, in an operation S1240, the battery diagnosing apparatus may display the information about the condition of the battery on at least one of a display of a vehicle, a terminal of a user, or any combination thereof.

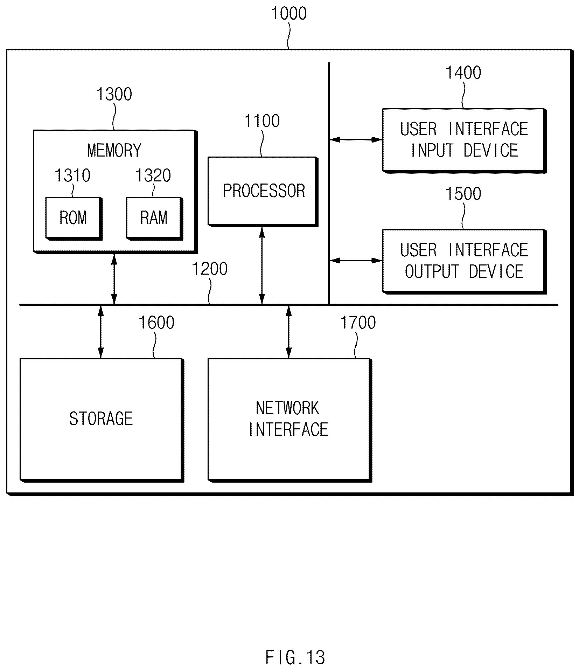

FIG. 13 is a diagram showing a computing system associated with a battery diagnosing apparatus or a battery diagnosing method, according to an embodiment of the present disclosure.

Referring to FIG. 13, a computing system 1000 may include at least one processor 1100, a memory 1300, a user interface input device 1400, a user interface output device 1500, storage 1600, and a network interface 1700, which are connected with each other via a bus 1200.

The processor 1100 may be a central processing unit (CPU) or a semiconductor device that processes instructions stored in the memory 1300 and/or the storage 1600. Each of the memory 1300 and the storage 1600 may include various types of volatile or nonvolatile storage media. For example, the memory 1300 may include a read only memory (ROM) 1310 and a random access memory (RAM) 1320.

Accordingly, the operations of the method or algorithm described in connection with embodiments disclosed in the specification may be directly implemented with a hardware module, a software module, or the combination of the hardware module and the software module, which is executed by the processor 1100. The software module may reside on a storage medium (i.e., the memory 1300 and/or the storage 1600) such as a random access memory (RAM), a flash memory, a read only memory (ROM), an erasable and programmable ROM (EPROM), an electrically an erasable and programmable ROM (EEPROM), a register, a hard disk drive, a removable disc, or a compact disc-ROM (CD-ROM).

The storage medium may be coupled to the processor 1100. The processor 1100 may read out information from the storage medium and may write information in the storage medium. Alternatively, the storage medium may be integrated with the processor 1100. The processor and storage medium may be implemented with an application specific integrated circuit (ASIC) . The ASIC may be provided in a user terminal. Alternatively, the processor and storage medium may be implemented with separate components in the user terminal.

The above description is merely illustrative of the technical idea of the present disclosure, and various modifications and variations may be made by one having ordinary skill in the art without departing from the essential characteristic of the present disclosure.

Accordingly, embodiments of the present disclosure are intended not to limit but to explain the technical idea of the present disclosure, and the scope and spirit of the present disclosure is not limited by the described embodiments. The scope of protection of the present disclosure should be construed by the attached claims, and all equivalents thereof should be construed as being included within the scope of the present disclosure.

Embodiments of the present disclosure may make a user aware of a battery condition by providing the user with information about the battery condition.

Embodiments of the present disclosure may provide a user with information that may cause the user to employ a battery control algorithm, by providing the user with information obtained by comparing the condition of a battery to which a battery control algorithm is applied with the condition of the battery to which the battery control algorithm is not applied.

Embodiments of the present disclosure may visually deliver information about a battery condition to the user.

Embodiments of the present disclosure may improve battery durability by providing a user with information that may cause the user to employ the battery control algorithm.

Embodiments of the present disclosure may reduce the failure rate of a battery by provide a user with information that may cause the user to employ the battery control algorithm.

In addition, a variety of effects directly or indirectly understood from the present disclosure may be provided.

Hereinabove, although the present disclosure was described with reference to example embodiments and the accompanying drawings, the present disclosure is not limited thereto, but may be variously modified and altered by those having ordinary skill in the art to which the present disclosure pertains without departing from the spirit and scope of the present disclosure claimed in the following claims.

### List of Reference Signs

- 100:: BATTERY DIAGNOSING APPARATUS
- 110:: PROCESSOR
- 120:: MEMORY
- 210:: PROCESS OF COLLECTING AND PREPROCESSING DATA
- 220:: PROCESS OF PRECISELY DIAGNOSING A CONDITION OF THE BATTERY
- 230:: PROCESS OF ANALYZING DATA ASSOCIATED WITH THE CONDITION OF THE BATTERY
- 240:: PROCESS OF PROVIDING A USER WITH INFORMATION
- 611:: SCORE OF A BATTERY OF A USER EMPLOYING LCM
- 612:: SCORE OF A BATTERY OF A USER NOT EMPLOYING LCM
- 613:: SCORE FOR THE CONDITION OF THE USER'S BATTERY

## Claims

1. A battery diagnosing apparatus comprising:
a memory configured to store computer-readable instructions; and
a processor configured to execute the computer-readable instructions,
wherein the processor is configured to:
obtain at least one of first battery data for a battery to which a battery control algorithm associated with battery control is applied, second battery data for a battery to which the battery control algorithm is not applied, or any combination thereof, and
generate information about a condition of the battery based on at least one of the first battery data, the second battery data, or any combination thereof.

2. The battery diagnosing apparatus of claim 1, wherein the processor is configured to:
determine at least one of at least one first parameter based on the first battery data, at least one second parameter based on the second battery data, or any combination thereof;
determine at least one of first data associated with the condition of the battery based on the at least one first parameter, second data associated with the condition of the battery based on the at least one second parameter, or any combination thereof; and
generate the information about the condition of the battery based on at least one of the first battery data, the second battery data, the first data associated with the condition of the battery, or the second data associated with the condition of the battery, or any combination thereof.

3. The battery diagnosing apparatus of claim 2, wherein the processor is configured to generate the information about the condition of the battery to include information obtained by comparing i) a first state of the battery according to the first data associated with the condition of the battery with ii) a second state of the battery according to the second data associated with the condition of the battery.

4. The battery diagnosing apparatus of claim 2 or 3, wherein the processor is configured to:
obtain data associated with a vehicle that uses the battery; and
generate the information about the condition of the battery based on at least one of the data associated with the vehicle, the first data associated with the condition of the battery, the second data associated with the condition of the battery, or any combination thereof.

5. The battery diagnosing apparatus of anyone of claims 2-4, wherein the processor is configured to:
determine the first data associated with the condition of the battery, based on at least one of the at least one first parameter, a correction constant corresponding to the at least one first parameter, an adjustment factor corresponding to the at least one first parameter, or any combination thereof; and
calculate the second data associated with the condition of the battery, based on at least one of the at least one second parameter, a correction constant corresponding to the at least one second parameter, an adjustment factor corresponding to the at least one second parameter, or any combination thereof.

6. The battery diagnosing apparatus of anyone of claims 2-5, wherein the processor is configured to convert the first data associated with the condition of the battery and the second data associated with the condition of the battery to predetermined indicators.

7. The battery diagnosing apparatus of claim 6, wherein the processor is configured to:
display information for recommending application of the battery control algorithm to the battery on at least one of a display of a vehicle, a terminal of a user, or any combination thereof, based on a result of comparing i) the first data associated with the condition of the battery converted to a predetermined indicator with ii) the second data associated with the condition of the battery converted to the predetermined indicator.

8. The battery diagnosing apparatus of anyone of claims 1-7, wherein the processor is configured to display a function associated with the battery control algorithm for the battery being used by a user, on at least one of a display of a vehicle, a terminal of a user, or any combination thereof, based on determining that the battery control algorithm is not being applied to the battery being used by the user.

9. The battery diagnosing apparatus of anyone of claims 1-8, wherein the processor is configured to generate first information obtained by comparing information about a condition of the battery of a user with at least one of information about conditions of batteries of other users who employ the battery control algorithm, information about conditions of batteries of other users who do not employ the battery control algorithm, or any combination thereof.

10. The battery diagnosing apparatus of anyone of claims 1-9, wherein the processor is configured to:
generate second information obtained by comparing i) information, corresponding to one or more types of reference data, about a condition of the battery of a user with at least one of information about conditions of batteries of other users who employ the battery control algorithm, ii) information, corresponding to the one or more types of reference data, about conditions of batteries of other users who do not employ the battery control algorithm, or iii) any combination thereof,
wherein the one or more types of reference data include at least one of state of charge (SOC) of the battery, state of health (SOH) of the battery, a degradation rate of the battery, a cooling load of the battery, a charging load of the battery, data associated with thermal control of the battery, power consumption efficiency of the battery, or any combination thereof.

11. The battery diagnosing apparatus of anyone of claims 1-10, wherein the processor is configured to:
generate third information, corresponding to a type of reference data from among the one or more types of reference data, about the condition of the battery of the user,
wherein the third information includes at least one of information about the condition of the battery of a user, information about conditions of batteries of multiple users including the user, information about conditions of batteries of other users other than the user, or any combination thereof.

12. The battery diagnosing apparatus of anyone of claims 1-11, wherein the processor is configured to:
generate fourth information, corresponding to a type of reference data from among the one or more types of reference data, about the condition of the battery of the user,
wherein the fourth information includes at least one of information about the condition of the battery of the user, information about conditions of the batteries of other users who employ the battery control algorithm, information about conditions of batteries of other users who do not employ the battery control algorithm, or any combination thereof.

13. The battery diagnosing apparatus of claim 2, or of anyone of claims 3-12 provided that in combination with claim 2, wherein the processor is configured to:
generate fifth information, corresponding to one or more types of reference data, obtained by comparing the first data converted into a predetermined indicator with the second data converted into the predetermined indicator,
wherein the fifth information includes information about a difference between the first data and the second data, and
wherein the one or more types of reference data include at least one of SOC of the battery, SOH of the battery, a degradation rate of the battery, a cooling load of the battery, a charging load of the battery, data associated with thermal control of the battery, power consumption efficiency of the battery, or any combination thereof.

14. A battery diagnosing method, the method comprising:
obtaining, by a processor, at least one of first battery data for a battery to which a battery control algorithm associated with control of a battery is applied, second battery data for a battery to which the battery control algorithm is not applied, or any combination thereof; and
generating, by the processor, information about a condition of the battery based on at least one of the first battery data, the second battery data, or any combination thereof.

15. The method of claim 14, further comprising:
determining, by the processor, at least one of at least one first parameter based on the first battery data, at least one second parameter based on the second battery data, or any combination thereof; and
determining, by the processor, at least one of first data associated with the condition of the battery based on the at least one first parameter, second data associated with the condition of the battery based on the at least one second parameter, or any combination thereof,
wherein generating the information about the condition of the battery includes generating the information about the condition of the battery based on at least one of the first data associated with the condition of the battery, the second data associated with the condition of the battery, or any combination thereof.
